(19) Europäisches Patentamt
European Patent Office
Office européen des brevets

(11) EP 1 736 829 A1

(12) EUROPEAN PATENT APPLICATION
published in accordance with Art. 158(3) EPC

(43) Date of publication:
**27.12.2006 Bulletin 2006/52**

(21) Application number: **05730408.1**

(22) Date of filing: **13.04.2005**

(51) Int Cl.:
*G03F 7/075* (2006.01) *G03F 7/004* (2006.01)
*G03F 7/039* (2006.01) *H01L 21/027* (2006.01)

(86) International application number:
**PCT/JP2005/007123**

(87) International publication number:
**WO 2005/101129 (27.10.2005 Gazette 2005/43)**

(84) Designated Contracting States:
**AT BE BG CH CY CZ DE DK EE ES FI FR GB GR HU IE IS IT LI LT LU MC NL PL PT RO SE SI SK TR**

(30) Priority: **16.04.2004 JP 2004122146**

(71) Applicant: **JSR Corporation**
**Tokyo 104-8410 (JP)**

(72) Inventors:
- **NISHIMURA, I.,**
  **JSR Corp.**
  **Tokyo 1048410 (JP)**
- **CHIBA, Takashi,**
  **c/o JSR Corp.**
  **Tokyo 1048410 (JP)**
- **SHIMOKAWA, Tsutomu,**
  **c/o JSR Corp.**
  **Tokyo 1048410 (JP)**

(74) Representative: **TBK-Patent**
**Bavariaring 4-6**
**80336 München (DE)**

(54) **RADIATION-SENSITIVE RESIN COMPOSITION**

(57) A radiation-sensitive resin composition exhibiting only extremely controlled change in the sensitivity after storage when used as a chemically-amplified resist possessing high transparency at a wavelength of 193 nm or less and particularly excellent depth of focus (DOF) is provided.

The radiation-sensitive resin composition comprises (A) a siloxane resin having a structural unit (I) shown by the following formula (I) and/or a structural unit (II) shown by the following formula (II), (B) a photoacid generator, and (C) a solvent, the content of nitrogen-containing compounds in the composition being not more than 100 ppm,

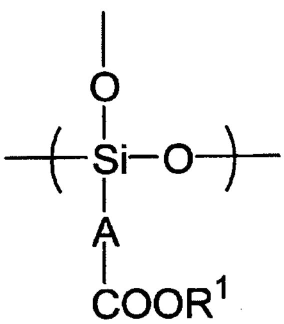

(I)

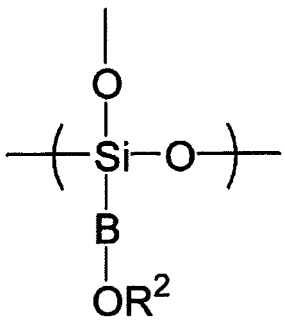

(II)

wherein A and B individually represent a substituted or unsubstituted divalent linear, branched, or cyclic hydrocarbon group, $R^1$ represents a monovalent acid-dissociable group, and $R^2$ represents a hydrogen atom or monovalent acid-dissociable group.



Printed by Jouve, 75001 PARIS (FR)

## Description

TECHNICAL FIELD

The present invention relates to a radiation-sensitive resin composition containing a specific siloxane resin suitable for microprocessing using various types of radiation such as deep ultraviolet radiation, electron beams, and X-rays.

BACKGROUND ART

A recent strong demand for high density and highly integrated LSIs (large-scale integrated circuits) radically accelerates miniaturization of wiring patterns.

Using short wavelength rays in a lithographic process is one method for miniaturizing wiring patterns. In recent years, deep ultraviolet rays typified by a KrF excimer laser (wavelength: 248 nm), an ArF excimer laser (wavelength: 193 nm), or an $F_2$ excimer laser (wavelength: 157 nm), electron beams, X rays, and the like are being used in place of ultraviolet rays such as g-line (wavelength: 436 nm), and i-line (wavelength: 365 nm).

Novolac resins, poly(vinylphenol) resins, and the like have been conventionally used as a resin component in resist compositions. However, because these resins exhibit strong absorbance at a wavelength of 193 nm due to inclusion of aromatic rings in the structure, a lithographic process by an ArF excimer laser, for example, using these resins cannot provide high accuracy corresponding to high photosensitivity, high resolution, and a high aspect ratio.

Therefore, a resin for use in a resist, transparent to a wavelength of 193 nm or less, particularly to an ArF excimer laser (wavelength: 193 nm) or an $F_2$ excimer laser (wavelength: 157 nm), and exhibiting the same or higher dry etching resistance as the resist resin containing aromatic rings, has been desired. A polysiloxane is one such a polymer. R. R. Kunz et al. of the MIT have reported their research results showing excellent transparency of a polysiloxane at a wavelength of 193 nm or less, particularly at 157 nm, describing superiority of this polymer as a resist material in a lithographic process using radiation with a wavelength of 193 nm or less (e.g. Non-patent Document 1, Non-patent Document 2). Moreover, polysiloxanes are known to exhibit excellent dry etching resistance. In particular, a resist containing polyorganosilsesquioxane having a ladder structure is known to possess high plasma resistance.

Several chemically amplified resist compositions using a siloxane polymer have also been reported. A radiation-sensitive resin composition comprising a polysiloxane having an acid-dissociable group such as a carboxylic acid ester group, phenol ether group, etc., on the side chain, bonded to a silicon atom via one or more carbon atoms has been disclosed (e.g. Patent Document 1). However, this polysiloxane cannot provide high resolution if the acid-dissociable carboxylic acid ester groups on the side chain do not efficiently dissociate. If a large number of acid-dissociable groups dissociate, on the other hand, the curing shrinkage stress of the resist film increases, causing cracks and peels in the resist film.

A positive tone resist using a polymer in which the carboxyl group of poly(2-carboxyethylsiloxane) is protected with an acid-dissociable group such as a t-butyl group has also been disclosed (e.g. Patent Document 2). Since this resist protects the carboxyl groups only insufficiently, it is difficult to develop the resist containing a large amount of carboxylic acid components remaining in the non-exposed area using a common alkaline developing solution.

A resist resin composition containing a polyorganosilsesquioxane having an acid-dissociable ester group has also been disclosed (e.g. Patent Document 3). This polyorganosilsesquioxane is prepared by the addition reaction of an acid-dissociable group-containing (meth)acryl monomer to a condensation product of vinyltrialkoxysilane, γ-methacryloxypropyltrialkoxysilane, or the like. The resin has a problem of insufficient transparency to light with a wavelength of 193 nm or less due to unsaturated groups originating from a (meth)acryl monomer remaining on the polymer side chains. The patent specification also describes a resist resin composition containing a polymer made by the esterification of polyhydroxycarbonylethylsilsesquioxane with t-butyl alcohol. This polymer also has the same problem as a resist as encountered by the polymer disclosed in Patent Document 2 due to a low degree of carboxyl group protection.

More recently, Patent Document 4 and Patent Document 5 have disclosed chemically amplified resists in which the resin component contains a siloxane-based resin or silicon-containing resin and a silicon-free resin, such as a resist containing a silsesquioxane polymer and a copolymer of 2-methyl-2-adamantyl methacrylate and mevalonic methacrylate or a resist containing a copolymer of p-hydroxystyrene and tris(trimethylsilyl)silyl methacrylate and a copolymer of p-hydroxystyrene and t-butyl methacrylate. The inventors of these patent applications claim that these chemically amplified resists excel in sensitivity, resolution, pattern-forming properties, dry etching resistance, and the like.

[Non-patent Document 1] J. Photopolym. Sci. Technol., Vol. 12, No. 4 (1999) P. 561-570
[Non-patent Document 2] SPIE, Vol.3678 (1999) P.13-23
[Patent Document 1] JP-A-5-323611
[Patent document 2] JP-A-8-160623
[Patent Document 3] JP-A-11-60733

[Patent document 4] JP-A-2000-221685

[Patent document 5] JP-A-2000-221686

In addition to excellent sensitivity, resolution, and pattern profile, however, a more recent demand for chemically amplified resists, which may contain a siloxane polymer, includes excellent depth of focus (DOF) and storage stability in accord with miniaturization of resist patterns.

DISCLOSURE OF THE INVENTION

An object of the present invention is to provide a radiation-sensitive resin composition exhibiting only extremely controlled change in the sensitivity after storage when used as a chemically-amplified resist possessing high transparency at a wavelength of 193 nm or less and particularly excellent depth of focus (DOF).

Other objects, features, and advantages of the invention will hereinafter become more readily apparent from the following description.

The present invention is described below in detail.

The radiation-sensitive resin composition of the present invention comprises (A) a siloxane resin having a structural unit (I) shown by the following formula (I) and/or a structural unit (II) shown by the following formula (II) (hereinafter referred to as "siloxane resin (A)"), (B) a photoacid generator (hereinafter referred to as "acid generator (B)"), and (C) a solvent, the content of nitrogen-containing compounds other than the components (A) to (C) in the composition being not more than 100 ppm,

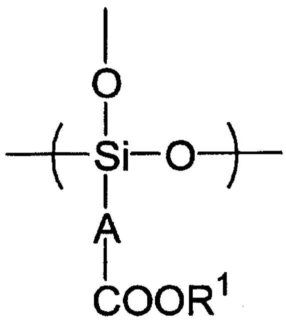

(I)

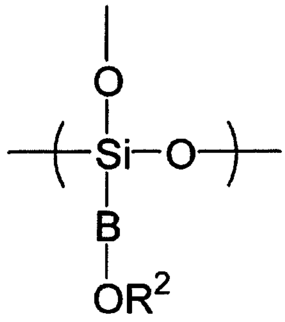

(II)

wherein A represents a substituted or unsubstituted divalent linear, branched, or cyclic hydrocarbon group having 1 to 20 carbon atoms, $R^1$ represents a monovalent acid-dissociable group, and B represents a substituted or unsubstituted divalent linear, branched, or cyclic hydrocarbon group having 1 to 20 carbon atoms, and $R^2$ represents a hydrogen atom or a monovalent acid-dissociable group.

Each component of the radiation-sensitive resin composition of the present invention will now be described.

Siloxane resin (A)

As examples of the divalent linear, branched, or cyclic hydrocarbon group having 1 to 20 carbon atoms represented by A in the formula (I), linear or branched alkylene groups such as a methylene group, 1,1-ethylene group, dimethylmethylene group, 1,2-ethylene group, trimethylene group, tetramethylene group, hexamethylene group, octamethylene group, and decamethylene group; cycloalkylene groups such as a 1,2-cyclobutylene group, 1,3-cyclobutylene group, 1,2-cyclopentylene group, 1,3-cyclopentylene group, 1,2-cyclohexylene group, 1,3-cyclohexylene group, 1,4-cyclohexylene group, 1,2-cycloheptylene group, 1,3-cycloheptylene group, 1,4-cycloheptylene group, 1,2-cyclooctylene group, 1,3-cyclooctylene group, and 1,4-cyclooctylene group; groups originating from bridged hydrocarbons such as adamantane, bicyclo[2.2.1]heptane, bicyclo[2.2.2]octane, tricyclo[5.2.1.$0^{2,6}$]decane, and tetracyclo[6.2.1.$1^{3,6}$.$0^{2,7}$]dodecane; groups originating from aromatic hydrocarbons such as benzene, toluene, ethylbenzene, i-propylbenzene, and naphthalene; the like can be given.

As examples of the substituents for the divalent hydrocarbon groups represented by A, in addition to acid-dissociable groups producing a carboxyl group, an alcoholic hydroxyl group, or a phenolic hydroxyl group by the action of an acid, a fluorine atom, hydroxyl group, carboxyl group, epoxy group, oxo group, amino group, cyano group, cyanyl group, isocyanyl group, (meth)acryloyl group, (meth)acryloyloxy group, group having a lactonyl group, group having a

carboxylic anhydride group, fluoroalkyl group having 1 to 4 carbon atoms, hydroxyalkyl group having 1 to 4 carbon atoms, cyanoalkyl group having 2 to 5 carbon atoms, alkoxyl group having 1-4 carbon atoms, alkoxymethyl group having 2 to 5 carbon atoms, alkoxycarbonyl group having 2 to 5 carbon atoms (excluding acid-dissociable groups), alkoxycarbonylamino group having 2 to 5 carbon atoms, alkoxysulfonyl group having 1-4 carbon atoms, and alkylaminosulfonyl group having 1 to 4 carbon atoms can be given.

Any number of one or more types of these substituents may be present in the substitution derivatives.

As A in the formula (I), groups derived from adamantane, bicyclo[2.2.1]heptane, or tetracyclo[6.2.1.$1^{3,6}$.$0^{2,7}$] dodecane, and groups obtainable by substituting these groups with one or more of a fluorine atom, trifluoromethyl group, and the like are preferable.

As preferable examples of the structural unit (I), units shown by the following formulas (I-1) to (I-5) can be given.

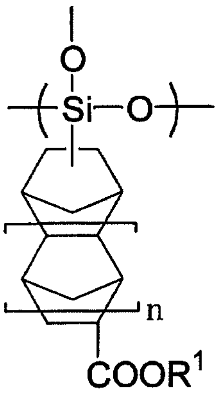

(I-1)

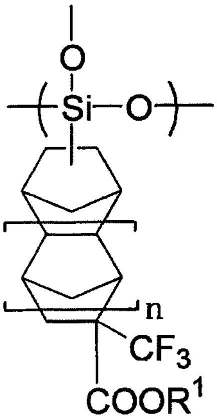

(I-2)

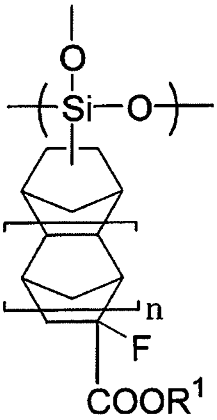

(I-3)

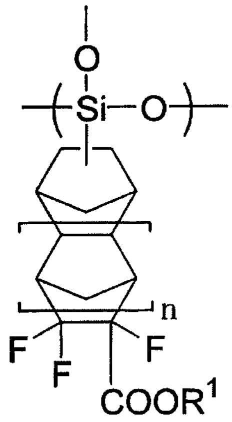

(I-4)

wherein n is 0 or 1,

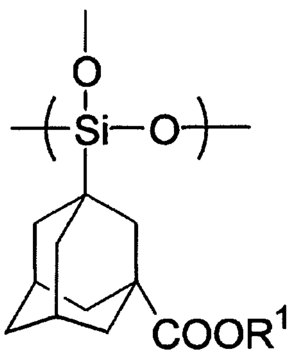

(I-5)

wherein $R^1$ is a monovalent acid-dissociable group such as groups of the following formulas (1-1) to (1-3), a monovalent cyclic hydrocarbon group having 3 to 20 carbon atoms, a monovalent heterocyclic group having 3 to 20 atoms, a trialkylsilyl group (wherein the carbon atom number of the alkyl group is 1 to 6), or an oxoalkyl group having 4 to20 carbon atoms.

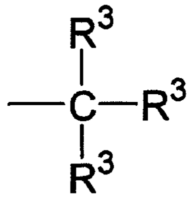

(1-1)

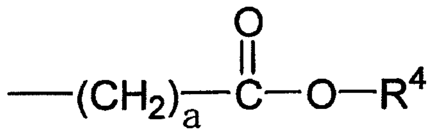

(1-2)

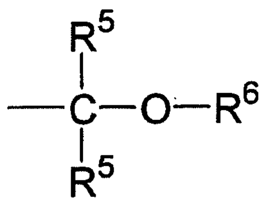

(1-3)

In the formula (1-1), $R^3$ individually represents a linear or branched alkyl group having 1 to 4 carbon atoms or a monovalent alicyclic hydrocarbon group having 4 to 20 carbon atoms or a substitution derivative thereof, or any two of $R^3$ groups bond together to form a divalent alicyclic hydrocarbon group having 4 to 20 carbon atoms or a substitution derivative thereof, with the remaining $R^3$ group being a linear or branched alkyl group having 1 to 4 carbon atoms or a monovalent alicyclic hydrocarbon group having 4 to 20 carbon atoms or a substitution derivative thereof.

In the formula (1-2), $R^4$ represents the group of the above formula (1-1), a monovalent cyclic hydrocarbon group having 3 to 20 carbon atoms, a monovalent heterocyclic group having 3 to 20 atoms, a trialkylsilyl group (wherein the carbon atom number of the alkyl group is 1 to 6), or an oxoalkyl group having 4 to 20 carbon atoms, and a represents an integer of 0 to 6.

In the formula (1-3), $R^5$ individually represents a hydrogen atom or a linear, branched, or cyclic alkyl group having 1 to 20 carbon atoms, $R^6$ represents a linear, branched, or cyclic monovalent hydrocarbon group having 1 to 20 carbon atoms or a monovalent heterocyclic group having 3 to 20 atoms, or two $R^5$ groups bond together or one of the $R^5$ groups bonds with $R^6$ to form a ring, wherein the alkyl group represented by $R^5$, the monovalent hydrocarbon group or monovalent heterocyclic group represented by $R^6$, the ring formed by two $R^5$ groups, and the ring formed by $R^5$ and $R^6$ may be substituted.

As examples of the linear or branched alkyl group having 1-4 carbon atoms represented by $R^3$ in the formula (1-1), a methyl group, ethyl group, n-propyl group, i-propyl group, n-butyl group, 2-methylpropyl group, 1-methylpropyl group, and t-butyl group can be given. As examples of the monovalent alicyclic hydrocarbon group having 4 to 20 carbon atoms represented by $R^3$ and the divalent alicyclic hydrocarbon group having 4 to 20 carbon atoms formed by two $R^3$ groups in combination, groups derived from a cycloalkane or cycloalkene such as cyclobutane, cyclopentane, cyclopentene, cyclohexane, cyclohexene, cycloheptane, or cyclooctane; groups derived from bridged hydrocarbons such as adamantane, bicyclo[2.2.1]heptane, bicyclo[2.2.2]octane, tricyclo[5.2.1.$0^{2,6}$]decane, or tetracyclo[6.2.1.$1^{3,6}$.$0^{2,7}$]dodecane; and the like can be given.

As examples of the substituents in the substitution derivative of the monovalent or divalent alicyclic hydrocarbon group, the same groups as mentioned for the substituents for divalent hydrocarbon groups represented by A in the formula (I) can be given.

Any number of one or more types of these substituents may be present in the substitution derivatives.

As examples of the groups represented by the formula (1-1), trialkylmethyl groups such as a t-butyl group, t-amyl group, 2-ethyl-2-butyl group, 3-methyl-3-pentyl group, and 1,1-diethylpropyl group; 1-alkylcycloalkyl groups such as a 1-methylcyclopentyl group, 1-ethylcyclopentyl group, 1-n-propylcyclopentyl group, 1-methylcyclohexyl group, 1-ethylcyclohexyl group, and 1-n-propylcyclohexyl group; alkyl-substituted bridged hydrocarbon groups such as a 2-methyladamantan-2-yl group, 2-methyl-3-hydroxyadamantan-2-yl group, 2-ethyladamantan-2-yl group, 2-ethyl-3-hydroxyadamantan-2-yl group, 2-n-propyladamantan-2-yl group, 2-n-butyladamantan-2-yl group, 2-methoxymethyladamantan-2-yl group, 2-methoxymethyl-3-hydroxyadamantan-2-yl group, 2-ethoxymethyladamantan-2-yl group, 2-n-propoxymethyladamantan-2-yl group, 2-methylbicyclo[2.2.1]heptan-2-yl group, 2-methyl-5-hydroxybicyclo[2.2.1]heptan-2-yl group, 2-methyl-6-hydroxybicyclo[2.2.1]heptan-2-yl group, 2-methyl-5-cyanobicyclo[2.2.1]heptan-2-yl group, 2-methyl-6-cyanobicyclo[2.2.1]heptan-2-yl group, 2-ethylbicyclo[2.2.1]heptan-2-yl group, 2-ethyl-5-hydroxybicyclo[2.2.1]heptan-2-yl group, 2-ethyl-6-hydroxybicyclo[2.2.1]heptan-2-yl group, 8-methyltricyclo[5.2.1.$0^{2,6}$]decan-8-yl group, 8-methyl-4-hydroxytricyclo[5.2.1.$0^{2,6}$]decan-8-yl group, 8-methyl-4-cyanotricyclo[5.2.1.$0^{2,6}$]decan-8-yl group, 8-ethyltricyclo [5.2.1.$0^{2,6}$]decan-8-yl group, 8-ethyl-4-hydroxytricyclo[5.2.1.$0^{2,6}$]decan-8-yl group, 4-methyltetracyclo[6.2.1.$1^{3,6}$.$0^{2,7}$]dodecan-4-yl group, 4-methyl-9-hydroxytetracyclo[6.2.1.$1^{3,6}$.$0^{2,7}$]dodecan-4-yl group, 4-methyl-10-hydroxytetracyclo [6.2.1.$1^{3,6}$.$0^{2,7}$]dodecan-4-yl group, 4-methyl-9-cyanotetracyclo[6.2.1.$1^{3,6}$.$0^{2,7}$]dodecan-4-yl group, 4-methyl-10-cyanotetracyclo[6.2.1.$1^{3,6}$.$0^{2,7}$]dodecan-4-yl group, 4-ethyltetracyclo[6.2.1.$1^{3,6}$.$0^{2,7}$]dodecan-4-yl group, 4-ethyl-9-hydroxytetracyclo[6.2.1.$1^{3,6}$.$0^{2,7}$]dodecan-4-yl group, and 4-ethyl-10-hydroxytetracyclo[6.2.1.$1^{3,6}$.$0^{2,7}$]dodecan-4-yl group; dialkylcycloalkylmethyl groups such as a 1-methyl-1-cyclopentylethyl group, 1-methyl-1-(2-hydroxycyclopentyl)ethyl group, 1-methyl-1-(3-hydroxycyclopentyl)ethyl group, 1-methyl-1-cyclohexylethyl group, 1-methyl-1-(3-hydroxycyclohexyl)ethyl group, 1-methyl-1-(4-hydroxycyclohexyl)ethyl group, 1-methyl-1-cycloheptylethyl group, 1-methyl-1-(3-hydroxycycloheptyl)ethyl group, and 1-methyl-1-(4-hydroxycycloheptyl)ethyl group; alkyl-substituted bridged hydrocarbon group-substituted methyl groups such as a 1-methyl-1-(adamantan-1-yl)ethyl group, 1-methyl-1-(3-hydroxyadamantan-1-yl)ethyl group, 1-methyl-1-(bicyclo[2.2.1]heptan-2-yl)ethyl group, 1-methyl-1-(5-hydroxybicyclo[2.2.1]heptan-2-yl)ethyl group, 1-methyl-1-(6-hydroxybicyclo[2.2.1]heptan-2-yl)ethyl group, 1-methyl-1-(tetracyclo[6.2.1.$1^{3,6}$.$0^{2,7}$]dodecan-4-yl)ethyl group, 1-methyl-1-(9-hydroxytetracyclo[6.2.1.$1^{3,6}$.$0^{2,7}$]dodecan-4-yl)ethyl group, 1-methyl-1-(10-hydroxytetracyclo[6.2.1.$1^{3,6}$.$0^{2,7}$]dodecan-4-yl)ethyl group, 1-methyl-1-(tricyclo[5.2.1.$0^{2,6}$]decan-8-yl)ethyl group, and 1-methyl-1-(4-hydroxytricyclo[5.2.1.$0^{2,6}$]decan-8-yl)ethyl group; alkyldicycloalkylmethyl groups such as a 1,1-dicyclopentylethyl group, 1,1-di(2-hydroxycyclopentyl)ethyl group, 1,1-di(3-hydroxycyclopentyl)ethyl group, 1,1-dicyclohexylethyl group, 1,1-di(3-hydroxycyclohexyl)ethyl group, 1,1-di(4-hydroxycyclohexyl)ethyl group, 1,1-dicycloheptylethyl group, 1,1-di(3-hydroxycycloheptyl)ethyl group, and 1,1-di(4-hydroxycycloheptyl)ethyl group; alkyl-substituted di(bridged hydrocarbon group)-substituted methyl groups such as a 1,1-di(adamantan-1-yl)ethyl group, 1,1-di-(3-hydroxyadamantan-1-yl)ethyl group, 1,1-di(bicyclo[2.2.1]heptan-2-yl)ethyl group, 1,1-di(5-hydroxybicyclo[2.2.1]heptan-2-yl)ethyl group, 1,1-di(6-hydroxybicyclo[2.2.1]heptan-2-yl)ethyl group, 1,1-di(tetracyclo[6.2.1.$1^{3,6}$.$0^{2,7}$]dodecan-4-yl)ethyl group, 1,1-di (9-hydroxytetracyclo[6.2.1.$1^{3,6}$.$0^{2,7}$]dodecan-4-yl)ethyl group, 1,1-di(10-hydroxytetracyclo[6.2.1.$1^{3,6}$.$0^{2,7}$]dodecan-4-yl) ethyl group, 1,1-di(tricyclo[5.2.1.$0^{2,6}$]decan-8-yl)ethyl group, and 1,1-di(4-hydroxytricyclo[5.2.1.$0^{2,6}$]decan-8-yl)ethyl group; and the like can be given.

As examples of the monovalent cyclic hydrocarbon group having 3 to 20 carbon atoms represented by $R^4$ in the formula (1-2), a cyclobutyl group, cyclopentyl group, cyclopentenyl group, cyclohexyl group, cyclohexenyl group, cycloheptyl group, cyclooctyl group, adamantan-1-yl group, bicyclo[2.2.1]heptan-2-yl group, bicyclo[2.2.2]octyl group, tricyclo[5.2.1.$0^{2,6}$]decan-3-yl group, and tetracyclo[6.2.1.$1^{3,6}$.$0^{2,7}$]dodecan-4-yl group can be given.

As examples of the monovalent heterocyclic group having 3-20 atoms represented by $R^4$, a 2-tetrahydrofuranyl group and 2-tetrahydropyranyl group can be given.

As examples of the trialkylsilyl group represented by $R^4$, a trimethylsilyl group, ethyldimethylsilyl group, methyldiethylsilyl group, triethylsilyl group, i-propyldimethylsilyl group, methyldi-i-propylsilyl group, tri-i-propylsilyl group, and t-butyldimethylsilyl group can be given.

As examples of the oxoalkyl group having 4 to 20 carbon atoms represented by $R^4$, a 3-oxocyclopentyl group, 3-oxocyclohexyl group, 4-oxocyclohexyl group, 4-methyl-2-oxooxan-4-yl group, and 5-methyl-2-oxooxolan-5-yl group can be given.

As examples of the groups represented by the formula (1-2), a t-butoxycarbonyl group, t-amyloxycarbonyl group, 1,1-diethylpropoxycarbonyl group, 1-methylcyclopentyloxycarbonyl group, 1-ethylcyclopentyloxycarbonyl group, 1-methylcyclohexyloxycarbonyl group, 1-ethylcyclohexyloxycarbonyl group, 1-methyl-2-cyclopentenyloxycarbonyl group, 1-ethyl-2-cyclopentenyloxycarbonyl group, (2-methyladamantan-2-yl)oxycarbonyl group, (2-ethyladamantan-2-yl)oxycarbonyl group, (2-methylbicyclo[2.2.1]heptan-2-yl)oxycarbonyl group, (2-ethylbicyclo[2.2.1]heptan-2-yl)oxycarbonyl group, t-butoxycarbonylmethyl group, t-amyloxycarbonylmethyl group, 1,1-diethylpropoxycarbonylmethyl group, 1-methylcyclopentyloxycarbonylmethyl group, 1-ethylcyclopentyloxycarbonylmethyl group, 1-methylcyclohexyloxycarbonylmethyl group, 1-ethylcyclohexyloxycarbonylmethyl group, 1-methyl-2-cyclopentenyloxycarbonylmethyl group, 1-ethyl-2-cyclopentenyloxycarbonylmethyl group, (2-methyladamantan-2-yl)oxycarbonylmethyl group, (2-ethyladamantan-2-yl)oxycarbonylmethyl group, (2-methylbicyclo[2.2.1]heptan-2-yl)oxycarbonylmethyl group, (2-ethylbicyclo[2.2.1] heptan-2-yl)oxycarbonylmethyl group, 2-tetrahydrofuranyloxycarbonylmethyl group, 2-tetrahydropyranyloxycarbonylmethyl group, 1-methoxyethoxycarbonylmethyl group, 1-ethoxyethoxycarbonylmethyl group, (1-methyl-1-cyclopentylethoxy)carbonylmethyl group, (1-methyl-1-cyclohexylethoxy)carbonylmethyl group, [1-methyl-1-(adamantan-1-yl)ethoxy]carbonylmethyl group, [1-methyl-1-(bicyclo[2.2.1] heptan-2-yl)ethoxy]carbonylmethyl group, 2-tetrahydrofuranyloxycarbonylmethyl group, 2-tetrahydropyranyloxycarbonylmethyl group, and the like can be given.

In the formula (1-3), as examples of the linear, branched, or cyclic alkyl group having 1 to 20 carbon atoms represented by $R^5$, a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, n-decyl group, cyclobutyl group, cyclopentyl group, cyclohexyl group, cycloheptyl group, and cyclooctyl group can be given.

As examples of the linear, branched, or cyclic monovalent hydrocarbon group having 1 to 20 carbon atoms represented by $R^6$ in the formula (1-3), linear or branched alkyl groups such as a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, and n-decyl group; cycloalkyl groups such as a cyclobutyl group, cyclopentyl group, cyclohexyl group, cycloheptyl group, and cyclooctyl group; groups originating from bridged hydrocarbons such as an adamantan-1-yl group, adamantan-2-yl group, bicyclo[2.2.1]heptan-2-yl group, bicyclo[2.2.2]octan-2-yl group, tricyclo[5.2.1.$0^{2,6}$]decan-3-yl group, and tetracyclo[6.2.1.$1^{3,6}$.$0^{2,7}$]dodecan-4-yl group; aryl groups such as a phenyl group, o-tolyl group, m-tolyl group, p-tolyl group, 1-naphthyl group, and 2-naphthyl group; and aralkyl groups such as a benzyl group, $\alpha$-methylbenzyl group, $\alpha,\alpha$-dimethylbenzyl group, and phenethyl group; and the like can be given.

As examples of the monovalent heterocyclic group having 3 to 20 atoms represented by $R^6$, groups originating from nonbridged heterocyclic compounds such as oxetane, thietane, tetrahydrofurane, tetrahydrothiofurane, tetrahydropyrane, or tetrahydrothiopyrane, and groups originating from bridged heterocyclic compounds such as compounds shown by the following formulas (1-3-1) to (1-3-4) can be given.

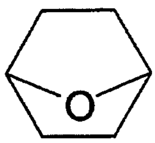
(1-3-1)

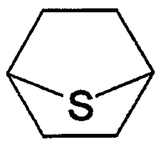
(1-3-2)

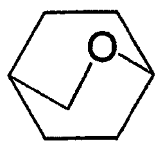
(1-3-3)

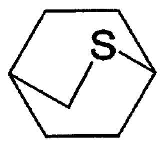
(1-3-4)

As examples of the ring formed by the two $R^5$ groups, 3 to 8 member rings formed with the carbon atoms to which the two $R^5$ groups bond can be given.

As examples of the ring formed by the $R^5$ and $R^6$, 3 to 8 member rings formed with the carbon atom to which $R^5$ bonds and the oxygen atom to which $R^6$ bonds can be given.

As examples of the substituents for the alkyl group represented by $R^5$, the monovalent hydrocarbon group and monovalent heterocyclic group represented by $R^6$, the ring formed from mutual bonding of the two $R^5$ groups, and the ring formed by bonding of one of the $R^5$ groups with the $R^6$ group, the same groups previously given as the substituents for the divalent hydrocarbon groups represented by A in the formula (I) can be given.

Any number of one or more types of these substituents may be present in the substitution derivatives.

As preferable specific examples of the substituted monovalent hydrocarbon group or substituted monovalent heterocyclic group represented by $R^6$ in the formula (1-3), a 4-hydroxy-n-butyl group, 6-hydroxy-n-hexyl group, 2-n-butoxyethyl group, 2-(2-hydroxyethoxy)ethyl group, (4-hydroxymethylcyclohexyl)methyl group, and the groups of the following formulas (1-3-5) to (1-3-8) can be given.

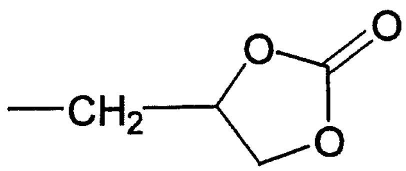
(1-3-5)

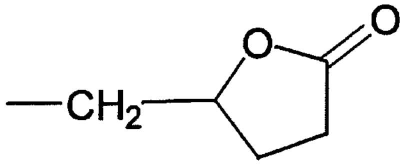

(1-3-6)

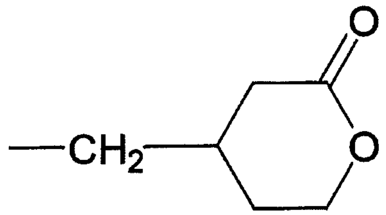

(1-3-7)

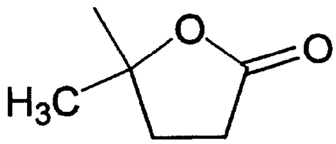

(1-3-8)

As examples of the groups represented by the formula (1-3), substituted methyl groups such as a methoxymethyl group, ethoxymethyl group, n-propoxymethyl group, i-propoxymethyl group, n-butoxymethyl group, t-butoxymethyl group, cyclopentyloxymethyl group, cyclohexyloxymethyl group, phenoxymethyl group, benzyloxymethyl group, and phenethyloxymethyl group; 1-substituted ethyl groups such as a 1-methoxyethyl group, 1-ethoxyethyl group, 1-n-propoxyethyl group, 1-i-propoxyethyl group, 1-n-butoxyethyl group, 1-t-butoxyethyl group, 1-cyclopentyloxyethyl group, 1-cyclohexyloxyethyl group, 1-phenoxyethyl group, 1-benzyloxyethyl group, and 1-phenethyloxyethyl group; 1-methyl-1-substituted ethyl groups such as a 1-methyl-1-methoxyethyl group, 1-methyl-1-ethoxyethyl group, 1-methyl-1-n-propoxyethyl group, 1-methyl-1-i-propoxyethyl group, 1-methyl-1-n-butoxyethyl group, 1-methyl-1-t-butoxyethyl group, 1-methyl-1-cyclopentyloxyethyl group, 1-methyl-1-cyclohexyloxyethyl group, 1-methyl-1-phenoxyethyl group, 1-methyl-1-benzyloxyethyl group, and 1-methyl-1-phenethyloxyethyl group; 1-substituted-n-propyl groups such as a 1-methoxy-n-propyl group, 1-ethoxy-n-propyl group, 1-n-propoxy-n-propyl group, and 1-phenoxy-n-propyl group; 2-substituted-n-propyl groups such as a 2-methoxy-n-propyl group, 2-ethoxy-n-propyl group, 2-n-propoxy-n-propyl group, and 2-phenoxy-n-propyl group; 1-substituted-n-butyl groups such as a 1-methoxy-n-butyl group, 1-ethoxy-n-butyl group, 1-n-propoxy-n-butyl group, and 1-phenoxy-n-butyl group; and heterocyclic group such as tetrahydrofuran-2-yl group, 2-methyltetrahydrofuran-2-yl group, tetrahydropyran-2-yl group, and 2-methyltetrahydropyran-2-yl group can be given.

As examples of the monovalent cyclic hydrocarbon groups having 3 to 20 carbon atoms represented by $R^1$ in the formula (I), the same groups as previously mentioned in connection with the monovalent cyclic hydrocarbon groups having 3 to 20 carbon atoms represented by $R^4$ in the formula (1-2) can be given.

As examples of the monovalent heterocyclic groups having 3 to 20 atoms represented by $R^1$, the same groups as previously mentioned in connection with the monovalent heterocyclic groups having 3 to 20 atoms represented by $R^4$ in the formula (1-2) can be given.

As examples of the trialkylsilyl groups represented by $R^1$, the same groups as previously mentioned in connection with the trialkylsilyl groups represented by $R^4$ in the formula (1-2) can be given.

As examples of the oxoalkyl groups having 4 to 20 carbon atoms represented by $R^1$, the same groups as previously mentioned in connection with the oxoalkyl groups having 4 to 20 carbon atoms represented by $R^4$ in the formula (1-2) can be given.

Of these monovalent acid-dissociable groups represented by $R^1$, the groups shown by the formulas (1-1) and (1-2) are preferable, with particularly preferable groups being a t-butyl group, 1-methylcyclopentyl group, 1-ethylcyclopentyl group, 1-methylcyclohexyl group, 1-ethylcyclohexyl group, 2-methyladamantan-2-yl group, 2-ethyladamantan-2-yl group, t-butoxycarbonylmethyl group, and the like.

The structural unit (I) may be used in the siloxane resin (A) either individually or in combination of two or more.

As examples of the linear, branched, or cyclic divalent hydrocarbon group having 1 to 20 carbon atoms represented by B in the formula (II), in addition to the groups given as examples of the linear, branched, or cyclic divalent hydrocarbon group having 1 to 20 carbon atoms represented by A in the formula (I), groups derived from bonding of a 2,2-bis(trifluoromethyl)-1,2-ethylene group with a group originating from a bridged hydrocarbons such as adamantane, bicyclo[2.2.1]heptane, bicyclo[2.2.2]octane, tricyclo[5.2.1.$0^{2,6}$]decane, or tetracyclo[6.2.1.$1^{3,6}$.$0^{2,7}$]dodecane can be given.

As examples of the substituents for the divalent hydrocarbon groups represented by B, the same groups as those given as the substituents for the linear, branched, or cyclic divalent hydrocarbon groups having 1 to 20 carbon atoms represented by A in the formula (I) can be given.

As B in the formula (II), groups derived from adamantane, bicyclo[2.2.1]heptane, or tetracyclo[6.2.1.$1^{3,6}$.$0^{2,7}$]dodecane; groups obtainable by bonding of a 2,2-bis(trifluoromethyl)-1,2-ethylene group with a group derived from adamantane, bicyclo[2.2.1]heptane, or tetracyclo[6.2.1.$1^{3,6}$.$0^{2,7}$]dodecane; groups obtainable by substitution one or more of a fluorine atom, trifluoromethyl group, and the like with any of these groups; and the like are preferable.

As preferable examples of the structural unit (II), units shown by the following formulas (II-1) to (II-10) can be given,

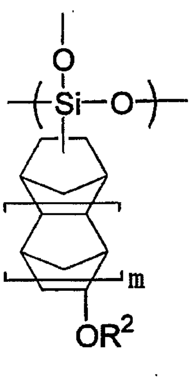
(II-1)

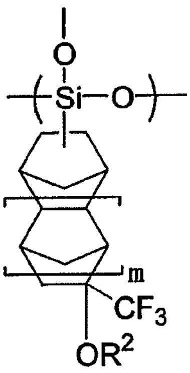
(II-2)

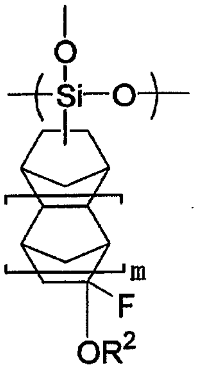
(II-3)

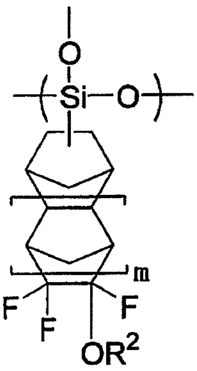
(II-4)

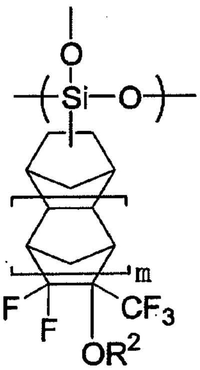
(II-5)

wherein m is 0 or 1,

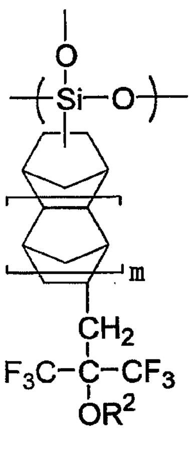
(II-6)

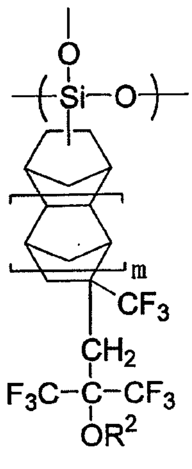
(II-7)

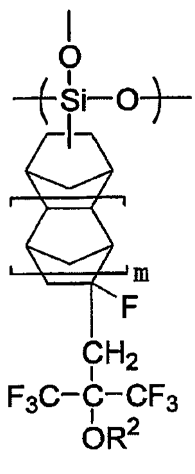
(II-8)

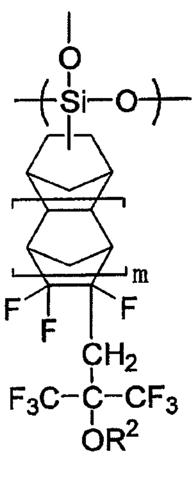
(II-9)

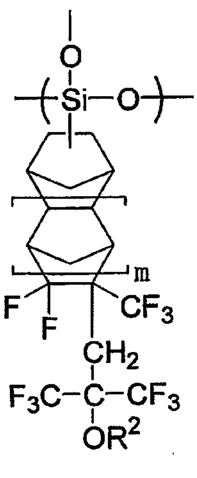
(II-10)

wherein m is 0 or 1.

As examples of the monovalent acid-dissociable group represented by $R^2$ in the formula (II), the same groups as those previously given for the monovalent acid-dissociable group $R^1$ in the formula (I) can be given.

As $R^2$ in the formula (II), a hydrogen atom, methoxymethyl group, ethoxymethyl group, n-propoxymethyl group, n-butoxymethyl group, t-butoxycarbonyl group, and the like are preferable.

The structural unit (II) may be used in the siloxane resin (A) either individually or in combination of two or more.

The siloxane resin (A) may further contain one or more structural units other than the structural unit (I) or the structural unit (II) (such other structural units are hereinafter referred to as "other structural units").

As the other structural units, structural units other than those described above originating from a silane compound with tri-functionality in regard to a condensation reaction such as a structural unit shown by the following formula (III),

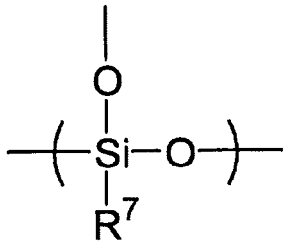

(III)

wherein $R^7$ represents a substituted or unsubstituted monovalent hydrocarbon group having 1 to 20 carbon atoms or a substituted or unsubstituted monovalent heterocyclic group having 3 to 20 atoms, and structural units originating from a silane compound with di- or tetra-functionality in regard to a condensation reaction can be given.

As examples of the monovalent hydrocarbon group having 1 to 20 carbon atoms represented by $R^7$ in the formula (III), linear or branched alkyl groups such as a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, and n-decyl group; cycloalkyl groups such as a cyclobutyl group, cyclopentyl group, cyclohexyl group, cycloheptyl group, and cyclooctyl group; groups originating from bridged hydrocarbons such as an adamantan-1-yl group, adamantan-2-yl group, bicyclo[2.2.1]heptan-2-yl group, bicyclo[2.2.2]octan-2-yl group, tricyclo[5.2.1.$0^{2,6}$]decan-3-yl group, and tetracyclo[6.2.1.$1^{3,6}$.$0^{2,7}$]dodecan-4-yl group; aryl groups such as a phenyl group, o-tolyl group, m-tolyl group, p-tolyl group, 1-naphthyl group, and 2-naphthyl group; aralkyl groups such as a benzyl group, $\alpha$-methylbenzyl group, $\alpha,\alpha$-dimethylbenzyl group, and phenethyl group; and the like can be given.

As examples of the monovalent heterocyclic group having 3 to 20 atoms represented by $R^7$, groups originating from nonbridged heterocyclic compounds such as oxetane, thietane, tetrahydrofurane, tetrahydrothiofurane, tetrahydropyrane, and tetrahydrothiopyrane, and groups originating from bridged heterocyclic compound such as compounds shown by the above formulas (1-3-1) to (1-3-4) can be given.

As examples of the substituent for the above monovalent hydrocarbon group and monovalent heterocyclic group of $R^7$, the same groups as mentioned for the substituents for the divalent hydrocarbon group represented by A in the formula (I) can be given.

Any number of one or more types of these substituents may be present in the substitution derivatives.

The siloxane resin (A) may be cross-linked intra-molecularly and/or inter-molecularly by an acid-dissociable coupling group shown by the following formula (2-1) or (2-2).

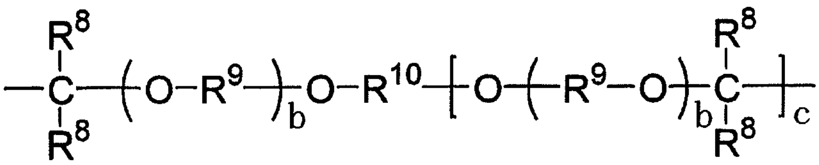

(2-1)

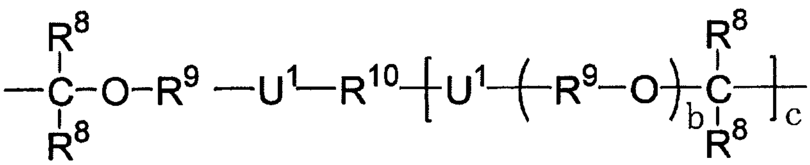

(2-2)

wherein $R^8$ individually represents a hydrogen atom, a linear, branched, or cyclic alkyl group having 1-8 carbon atoms, or two $R^8$ groups bonding to the same carbon atom may bond together to form a 3-8 member carbon ring; $R^9$ individually

represents a methylene group or a linear, branched, or cyclic alkylene group having 2-10 carbon atoms; b individually represents an integer of 0-10; c individually represents an integer of 1-7; $R^{10}$ individually represents a linear or branched saturated hydrocarbon group having 1 to 50 carbon atoms with a valence of (c + 1), a saturated cyclic hydrocarbon group having 3 to 50 carbon atoms with a valence of (c + 1), an aromatic hydrocarbon group having 6 to 50 carbon atoms with a valence of (c + 1), or a heterocyclic group having 3 to 50 atoms with a valence of (c + 1), wherein the linear or branched saturated hydrocarbon group, saturated cyclic hydrocarbon group, aromatic hydrocarbon group, and heterocyclic group may have a hetero atom in the main chain and/or the side chain and at least a part of the hydrogen atoms bonding to the carbon atoms may be replaced with a fluorine atom, hydroxyl group, carboxyl group, or acyl group, and $U^1$ individually represents -COO-, -NHCOO-, or -NHCONH-.

Specific preferable examples of the acid-dissociable coupling groups include the groups of the following formulas (2-1-1) to (2-1-8).

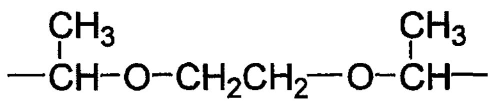
(2-1-1)

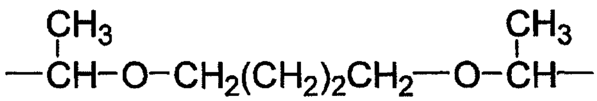
(2-1-2)

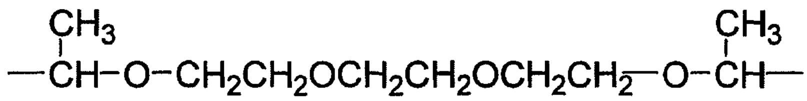
(2-1-3)

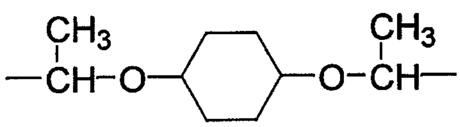
(2-1-4)

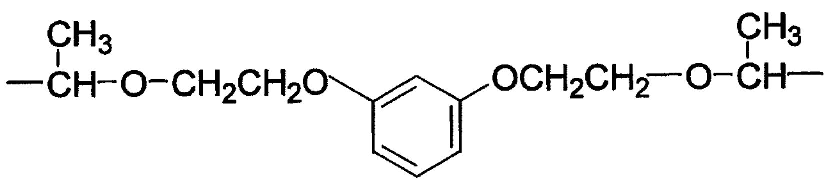
(2-1-5)

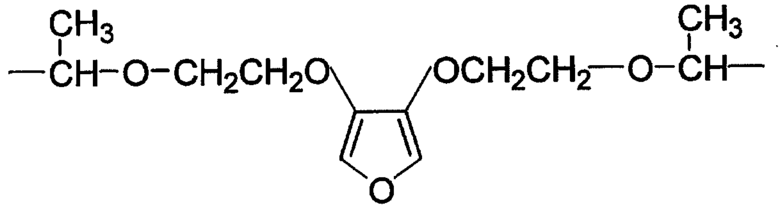
(2-1-6)

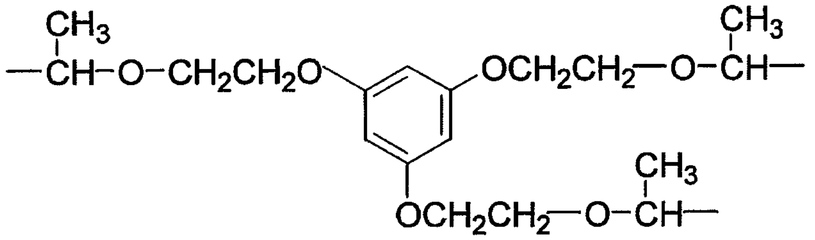

(2-1-7)

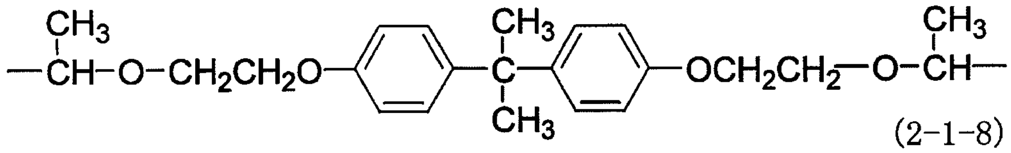

(2-1-8)

In the siloxane resin (A), the total amount of the structural unit (I) and the structural unit (II) is usually 10 to 100 mol%, preferably 10 to 80 mol%, and particularly preferably 20 to 60 mol%, with the content of the other structural unit being usually 90 mol% or less, and preferably 85 mol% or less. If the content of the total amount of the structural unit (I) and the structural unit (II) is less than 10 mol%, resolution tends to decrease.

The content of the structural unit (I) is preferably 10 to 90 mol%, more preferably 15 to 60 mol%, and particularly preferably 15 to 50 mol%, and the content of the structural unit (II) is preferably 1 to 70 mol%, more preferably 3 to 50 mol%, and particularly preferably 3 to 40 mol%. If the content of the structural unit (I) is less than 10 mol%, resolution tends to decrease; if more than 70 mol%, dry etching resistance tends to decrease. If the content of the structural unit (II) is less than 1 mol%, adhesiveness tends to decrease; if more than 70 mol%, dry etching resistance tends to decrease.

The polystyrene-reduced weight average molecular weight of the siloxane resin (A) determined by gel permeation chromatography (GPC) (hereinafter referred to as "Mw") is usually 500 to 1,000,000, preferably 5,000 to 100,000, and particularly preferably 500 to 40,000. If the Mw of the siloxane resin (A) is less than 500, the glass transition temperature of the resin tends to decrease. If the Mw exceeds 1,000,000, solubility of the resin in solvents tends to decrease.

Method for preparation of siloxane resin (A)

The siloxane resin (A) having a structural unit (I) and/or a structural unit (II) in which the $R^2$ is a monovalent acid-dissociable group is prepared by polycondensation of condensable silane compounds corresponding to the structural unit (I) (for example, a trichlorosilane compound, triethoxysilane compound, etc.) and/or condensable silane compounds corresponding to the structural unit (II).

The siloxane resin (A) having a structural unit (II) in which the $R^2$ is a hydrogen atom can be prepared by protecting the alcoholic hydroxyl group or phenolic hydroxyl group in a condensable silane compound corresponding to the structural unit (II) with an acetyl group or a lower alkyl group (e.g. a methyl group, an ethyl group, etc.), for example, polycondensing the condensable silane compound, and dissociating the acetyl group or lower alkyl group.

The siloxane resin (A) having an acid-dissociable group can also be prepared by introducing a monovalent acid-dissociable group $R^1$ and/or a monovalent acid-dissociable group $R^2$ into the carboxyl group, alcoholic hydroxyl group, or phenolic hydroxyl group of the siloxane resin (A) having the structural unit (I) in which the monovalent acid-dissociable group $R^1$ dissociated and/or the structural unit (II) in which $R^2$ is a hydrogen atom.

The method for preparing the siloxane resin (A) and the method for synthesizing a condensable silane compound used for preparing the siloxane resin (A) are also described in Patent Documents 6 to 8, for example.

[Patent document 6] JP-A-2002-268225

[Patent document 7] JP-A-2002-268226

[Patent document 8] JP-A-2002-268227

Polycondensation of condensable silane compounds for producing the siloxane resin (A) can be carried out in the presence of an acidic catalyst or a basic catalyst in a solvent or without using a solvent. In the present invention, polycondensation in the presence of an acidic catalyst or polycondensation in the presence of an acidic catalyst followed by reaction in the presence of a basic catalyst is preferable.

The polycondensation method for producing the siloxane resin (A) will now be described.

As examples of the acidic catalyst, hydrochloric acid, sulfuric acid, nitric acid, formic acid, acetic acid, n-propionic acid, butyric acid, valeric acid, oxalic acid, malonic acid, succinic acid, maleic acid, fumaric acid, adipic acid, phthalic acid, terephthalic acid, acetic anhydride, maleic anhydride, citric acid, boric acid, phosphoric acid, titanium tetrachloride, zinc chloride, aluminium chloride, benzenesulfonic acid, p-toluenesulfonic acid, and methanesulfonic acid can be given.

Of these acidic catalysts, hydrochloric acid, sulfuric acid, acetic acid, oxalic acid, malonic acid, maleic acid, fumaric acid, acetic anhydride, maleic anhydride, and the like are preferable.

These acidic catalysts may be used either individually or in combination of two or more.

The acidic catalysts are usually used in the amount of 0.01-10,000 parts by weight, for 100 parts by weight of all of the silane compounds.

As the basic catalyst, an inorganic base such as lithium hydroxide, sodium hydroxide, potassium hydroxide, calcium hydroxide, barium hydroxide, sodium hydrogencarbonate, potassium hydrogencarbonate, sodium carbonate, and potassium carbonate can be used.

In addition, the following organic bases can also be used as the basic catalyst: linear, branched, or cyclic monoalkylamines such as n-hexylamine, n-heptylamine, n-octylamine, n-nonylamine, n-decylamine, and cyclohexylamine; linear, branched, or cyclic dialkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; linear, branched, or cyclic trialkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine, and tricyclohexylamine; aromatic amines such as aniline, N-methylaniline, N,N-dimethylaniline, 2-methylaniline, 3-methylaniline, 4-methylaniline, 4-nitroaniline, diphenylamine, triphenylamine, and naphthylamine; diamines such as ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, and 1,3-bis[1-(4-aminophenyl)-1-methylethyl]benzene; imidazoles such as imidazole, benzimidazole, 4-methylimidazole, and 4-methyl-2-phenylimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine and 1-(2'-hydroxyethyl)piperazine; other nitrogen-containing heterocyclic compounds such as pyrazine, pyrazole, pyridazine, quinoxaline, purine, pyrrolidine, piperidine, morpholine, 4-methylmorpholine, 1,4-dimethylpiperazine, and 1,4-diazabicyclo[2.2.2]octane; and the like can be given.

Of these basic catalysts, triethylamine, tri-n-propylamine, tri-n-butylamine, pyridine, and the like are preferable.

These basic catalysts may be used either individually or in combination of two or more.

The basic catalyst is usually used in the amount of 0.01-10,000 parts by weight for 100 parts by weight of all of the silane compounds.

As examples of the solvent used in the polycondensation, linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; alcohols such as ethanol, n-propanol, i-propanol, n-butanol, t-butanol, cyclohexanol, ethylene glycol monomethyl ether, ethylene glycol monoethyl ether, ethylene glycol mono-n-propyl ether, ethylene glycol mono-n-butyl ether, propylene glycol monomethyl ether, propylene glycol monoethyl ether, and propylene glycol mono-n-propyl ether; dialkylene glycol dialkyl ethers such as diethylene glycol dimethyl ether, diethylene glycol diethyl ether, diethylene glycol di-n-propyl ether, and diethylene glycol di-n-butyl ether; ethylene glycol monoalkyl ether acetates such as ethylene glycol monomethyl ether acetate, ethylene glycol monoethyl ether acetate, and ethylene glycol mono-n-propyl ether acetate; aromatic hydrocarbons such as toluene and xylene; other esters such as ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, and ethyl pyruvate; N-methylpyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate,

γ-butyrolactone, ethylene carbonate, propylene carbonate; and the like can be given.

These solvents may be used either individually or in combination of two or more.

These solvents are usually used in the amount of 2,000 parts by weight or less for 100 parts by weight of all of the silane compounds.

The polycondensation reaction for producing the siloxane resin (A) can be preferably carried out either in the presence or absence of a solvent, such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, 2-octanone, cyclopentanone, 3-methylcyclopentanone, cyclohexanone, 2-methylcyclohexanone, 2,6-dimethylcyclohexanone, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, and ethylene glycol mono-n-propyl ether acetate.

In addition, water may be added to the reaction mixture of the polycondensation reaction. The amount of water to be added is usually 10,000 parts by weight or less for 100 parts by weight of all of the silane compounds. Under the acidic or basic conditions, the polycondensation reaction is carried out at a temperature of usually -50 to 300°C, and preferably 20 to 100°C, usually for a period of one minute to 100 hours.

The siloxane resin (A) is preferably used after purification in the present invention.

The following methods can be given as example of preferable purification method of the siloxane resin (A) of the present invention.

(1) A method of mixing the siloxane resin (A) or a solution of the siloxane resin (A) in a solvent (a) having an ethanol solubility (25°C) of 100 g/100 g or more (excluding monohydric or polyhydric aliphatic alcohols having 1 to 3 carbon atoms and free hydroxyl group-containing alkyl ethers (the alkyl group containing 1 to 10 carbon atoms) of a polyhydric aliphatic alcohol having 1 to 10 carbon atoms), with a solvent (A), which is one or more solvents selected from monohydric or polyhydric aliphatic alcohols having 1 to 3 carbon atoms, to prepare a solution of the siloxane resin (A) in a solvent containing the solvent (A), adding at least one solvent selected from the group consisting of hydrocarbons having 5 to 10 carbon atoms to the solution to effect phase separation, and recovering purified siloxane resin (A) from the solvent (A) phase (hereinafter referred to as "purification method (1)").

(2) A method of mixing the siloxane resin (A) or a solution of the siloxane resin (A) in the solvent (a) with a solvent (B), which is a mixture of water and at least one solvent selected from the group consisting of monohydric or polyhydric aliphatic alcohols having 1 to 10 carbon atoms and free hydroxyl group-containing alkyl ethers (the alkyl group containing 1 to 10 carbon atoms) of a polyhydric aliphatic alcohol having 1 to 10 carbon atoms, in which the amount of water is 0.001 to 50 wt%" to prepare a solution of polysiloxane in a solvent containing the solvent (B), adding at least one solvent selected from the group consisting of hydrocarbons having 5 to 10 carbon atoms to the solution to effect phase separation, and recovering purified siloxane resin (A) from the solvent (B) phase (hereinafter referred to as "purification method (2)").

These purification methods will now be discussed.

The siloxane resin (A) to be purified in the present invention may be either a prepared siloxane resin or a procured siloxane resin. When a solution of siloxane resin (A) is purified, the solvent used for polycondensation for preparing the siloxane resin (A) may be used as the solvent (a), if such a solvent satisfies the above-mentioned ethanol solubility conditions.

As examples of the solvent (a) used for the purification methods (1) and (2), linear or branched ketones such as 2-butanone, 2-pentanone, 3-methyl-2-butanone, 2-hexanone, 3-methyl-2-pentanone, 4-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 3-alkoxypropionates such as methyl 3-methoxypropionate, ethyl 3-methoxypropionate, methyl 3-ethoxypropionate, and ethyl 3-ethoxypropionate; other esters such as ethyl acetate, n-propyl acetate, n-butyl acetate, 3-methoxybutyl acetate, 3-methyl-3-methoxybutyl acetate, ethyl ethoxyacetate, methyl acetoacetate, ethyl acetoacetate, 3-methyl-3-methoxybutyl propionate, 3-methyl-3-methoxybutyl butyrate, methyl pyruvate, and ethyl pyruvate; N-methylpyrrolidone, N,N-dimethylformamide, N,N-dimethylacetamide, dimethylsulfoxide, benzyl ethyl ether, di-n-hexyl ether, caproic acid, caprylic acid, benzyl acetate, ethyl benzoate, diethyl oxalate, diethyl maleate, γ-butyrolactone, ethylene carbonate, propylene carbonate; and the like can be given.

Of these, 2-butanone, 2-pentanone, cyclohexanone, propylene glycol monomethyl ether acetate, ethyl acetate, n-butyl acetate, γ-butyrolactone , and the like are preferable as the solvent (a).

These solvents may be used either individually or in combination of two or more.

The concentration of the siloxane resin (A) in the solution of the siloxane resin (A) in the solvent (a) is usually

10 to 90 wt%, preferably 30 to 80 wt%, and more preferably 50 to 80 wt%. If the concentration of the siloxane resin (A) is less than 10 wt%, the recovery rate of the resin tends to decrease. If more than 90 wt%, handling of the resin solution tends to be difficult.

As examples of the monohydric or polyhydric aliphatic alcohol having 1 to 10 carbon atoms (hereinafter referred to as "lower aliphatic alcohol") used in the purification methods (1) and (2), methanol, ethanol, n-propanol, i-propanol, ethylene glycol, propylene glycol, 1,4-butanediol, 1,2,3-propane triol, glycerol, and the like can be given.

Of these lower aliphatic alcohols, methanol, ethanol, n-propanol, and the like are preferable, with methanol and the like being particularly preferable.

These lower aliphatic alcohols can be used either individually or in combination of two or more in the purification methods (1) and (2).

As examples of the free hydroxyl group-containing alkyl ether of a polyhydric aliphatic alcohol having 1 to 10 carbon atoms (the alkyl group containing 1 to 10 carbon atoms, and preferably 1 to 3 carbon atoms) (hereinafter referred to as "free hydroxyl group-containing polyhydric alcohol derivative") used for the purification method (2), ethylene glycol derivatives such as ethylene glycol monomethyl ether, ethylene glycol monoethyl ether, ethylene glycol mono-n-propyl ether, and ethylene glycol mono-n-butyl ether; propylene glycol derivatives such as propylene glycol monomethyl ether, propylene glycol monoethyl ether, and propylene glycol mono-n-propyl ether; diethylene glycol derivatives such as diethylene glycol monomethyl ether, diethylene glycol monoethyl ether, diethylene glycol mono-n-propyl ether, and diethylene glycol mono-n-butyl ether; dipropylene glycol derivatives such as dipropylene glycol monomethyl ether, dipropylene glycol monoethyl ether, dipropylene glycol mono-n-propyl ether, and dipropylene glycol mono-n-butyl ether; and the like can be given.

Of these hydroxyl group-containing polyhydric alcohol derivatives, ethylene glycol monomethyl ether, ethylene glycol monoethyl ether, propylene glycol monomethyl ether, propylene glycol monoethyl ether, diethylene glycol monomethyl ether, dipropylene glycol monomethyl ether, and the like are preferable.

These free hydroxyl group-containing polyhydric alcohol derivatives may be used either individually or in combination of two or more.

The content of water in the solvent (B) used in the purification method (2) is from 0.001 to 50 wt%, preferably from 0.01 to 20 wt%, and still more preferably from 0.01 to 15 wt%. If the water content is less than 0.001 wt%, phase separation performance tends to decrease; if more than 50 wt%, the solubility of the siloxane resin

(A) tends to decrease.

In the purification method (1), the concentration of the siloxane resin (A) in the solution of the siloxane resin (A) in the solvent containing the solvent (A) is usually 1 to 60 wt%, preferably 1 to 50 wt%, and more preferably 5 to 40 wt%. If the concentration of the siloxane resin (A) is less than 1 wt%, processability of industrial scale production tends to decrease. If more than 50 wt%, impurity rejection performance tends to decrease.

In the purification method (2), the concentration of polysiloxane in the solution of the siloxane resin (A) in the solvent containing the solvent (B) is usually 1 to 60 wt%, preferably 1 to 50 wt%, and more preferably 5 to 40 wt%. If the concentration of the siloxane resin (A) is less than 1 wt%, processability of industrial scale production tends to decrease. If more than 50 wt%, impurity rejection performance tends to decrease.

The siloxane resin (A) solution in the solvent containing the solvent (A) in the purification method (1) and the siloxane resin (A) solution in the solvent containing the solvent (B) in the purification method (2) are prepared by processing the solvent and the siloxane resin (A) at a temperature usually from 0 to 40°C, and preferably from 15 to 35°C, for a period of 5 minutes to 24 hours, and preferably 10 minutes to 3 hours.

As examples of the hydrocarbon having 5 to 10 carbon atoms (hereinafter referred to as "hydrocarbon solvent") used in the purification methods (1) and (2), aliphatic hydrocarbons such as n-pentane, i-pentane, n-pentane, i-pentane, n-heptane, i-heptane, n-octane, i-octane, n-pentane, and n-decane; alicyclic hydrocarbons such as cyclopentane, and cyclohexane; unsaturated aliphatic hydrocarbons such as pentene, heptene, and octene; aromatic hydrocarbons such as benzene, toluene, and xylene; and the like can be given.

Of these hydrocarbon solvents, aliphatic hydrocarbons are preferable, with n-hexane, n-heptane, and the like being particularly preferable.

The amount of the hydrocarbon solvents used in the purification methods (1) and (2) is usually from 100 to 10,000 parts by weight, preferably from 100 to 5,000 parts by weight, and still more preferably from 200 to 2,000 parts by weight for 100 parts by weight of the siloxane resin (A). If the amount of the hydrocarbon solvents used is less than 100 wt%, impurity rejection performance tends to decrease. If more than 10,000 wt%, processability of industrial scale production tends to decrease.

The siloxane resin (A) solution in the hydrocarbon solvent in the purification method (1) and the purification method (2) are prepared by processing the solvent and the siloxane resin (A) at a temperature usually from 0 to 40°C, and preferably from 15 to 35°C, for a period of 5 minutes to 24 hours, and preferably 10 minutes to 3 hours. In the

process, after adding the hydrocarbon solvent to the siloxane resin (A) solution and mixing, the mixture is preferably allowed to stand at a temperature of from 0 to 40°C, and preferably from 15 to 35°C, for 10 minutes or more, and preferably 30 minutes or more. Then, the lower layer in the two separated layers is recovered. The procedure of the addition and mixing of the hydrocarbon solvent for phase separation, followed by recovery of lower layer may be repeated one or more times as required. Since the separated layer is a solution not containing aggregates, the process can be easily carried out.

After that, the solvent is removed from the separated layer by distillation under reduced pressure, for example, as required, to obtain purified siloxane resin (A).

There are no specific limitations to the method of mixing in the process of the purification method (1) and the purification method (2). An appropriate stirring means such as a propeller-type, a flat blade-type, a curved blade-type, a Pfaudler-type, a blue margin-type, and the like can be used.

Impurities can be easily and efficiently removed from the siloxane resin (A) by using such purification methods.

The content of nitrogen-containing compounds, in particular, in the purified siloxane resin (A) can be reduced usually to 200 ppm or less, preferably 150 ppm or less, and particularly preferably 100 ppm or less. Since processing in the state of a solution is possible without drying the resin when used particularly as a resin component of a chemically amplified resist, not only can the resist be prevented from being denatured into the state difficult to be re-dissolved, but also is free from problems such as sublimation of low molecular components which may be produced if impurities are not removed.

Acid generator (B)

The component (B) in the present invention comprises a photoacid generator (hereinafter referred to as "acid generator (B)") which generates an acid by exposure to radiation and causes an acid-dissociable group in the siloxane resin (A) to dissociate by the action of the acid. As a result, exposed areas of the resist film become readily soluble in an alkaline developer, whereby a positive-tone resist pattern is formed.

The type of the acid generator (B) is not specifically limited insofar as it can exhibit the above action. A preferable acid generator (B) preferably contains a compound that generates trifluoromethansulfonic acid or an acid shown by the following formula (3) (hereinafter referred to as "acid (3)") upon exposure (hereinafter referred to as "acid generator (B1)").

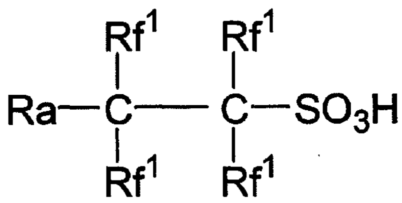

(3)

wherein $Rf^1$ individually represents a fluorine atom or trifluoromethyl group, Ra represents a hydrogen atom, fluorine atom, linear or branched alkyl group having 1 to 20 carbon atoms, linear or branched fluoroalkyl group having 1 to 20 carbon atoms, substituted or unsubstituted monovalent cyclic hydrocarbon group having 3 to 20 carbon atoms, or substituted or unsubstituted monovalent cyclic fluorohydrocarbon group having 3 to20 carbon atoms.

As examples of the acid generator (B1), onium salts, sulfone compounds, sulfonic acid compounds, carboxylic acid compounds, diazoketone compounds, and halogen-containing compounds can be given.

In the present invention, although the acid generator (B1) can be used alone as the acid generator (B), the acid generator (B1) can be used in combination with an acid generator (B) (hereinafter referred to as "acid generator (B2)") which generates an acid shown by the following formula (4) ("acid (4)"), an acid shown by the following formula (5) ("acid (5)"), or an acid shown by the following formula (6) ("acid (6)").

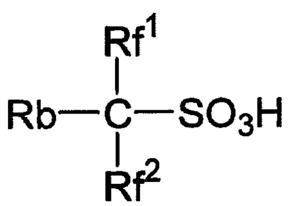

(4)

**Rs- SO3H (5)**

**Rc- COOH (6)**

In the formula (4), $Rf^1$ represents a fluorine atom or trifluoromethyl group, $Rf^2$ represents a hydrogen atom, fluorine atom, methyl group, or trifluoromethyl group, Rb represents a hydrogen atom, a linear or branched alkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms.

In the formula (5), Rs represents a linear or branched alkyl group having 1 to 20 carbon atoms or a substituted or unsubstituted monovalent cyclic hydrocarbon group having 3 to 20 carbon atoms.

In the formula (6), Rc represents a linear or branched alkyl group having 1 to 20 carbon atoms, a linear or branched fluoroalkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms.

As specific examples of the linear or branched alkyl group having 1 to 20 carbon atoms represented by Ra, Rb, Rs, or Rc in the formulas (3) to (6), a methyl group, ethyl group, n-propyl group, i-propyl group, n-butyl group, i-butyl group, sec-butyl group, t-butyl group, n-pentyl group, n-hexyl group, n-heptyl group, and n-octyl group can be given. As specific examples of the linear or branched fluoroalkyl group having 1 to 20 carbon atoms represented by Ra or Rc, a trifluoromethyl group, pentafluoroethyl group, heptafluoro-n-propyl group, heptafluoro-i-propyl group, nonafluoro-n-butyl group, nonafluoro-i-butyl group, nonafluoro-sec-butyl group, nonafluoro-t-butyl group, perfluoro-n-pentyl group, perfluoro-n-hexyl group, perfluoro-n-heptyl group, and perfluoro-n-octyl group can be given.

As examples of the monovalent cyclic hydrocarbon group having 3 to 20 carbon atoms, the monovalent cyclic fluorohydrocarbon group having 3 to 20 carbon atoms, or their substitution derivatives represented by Ra, Rb, Rs, or Rc, groups of the following formulas (7)-(13) can be given.

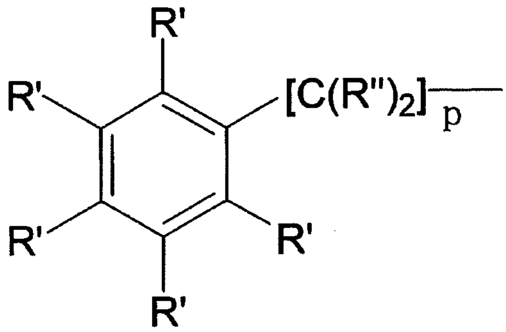

(7)

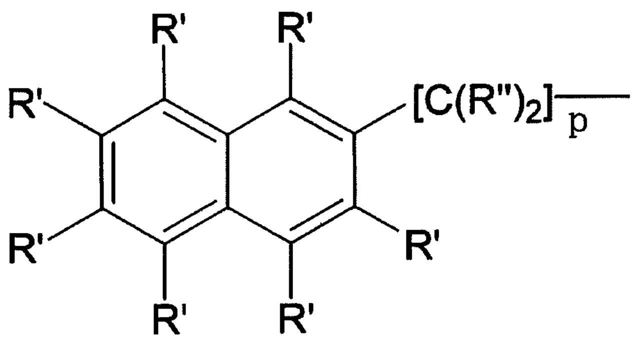

(8)

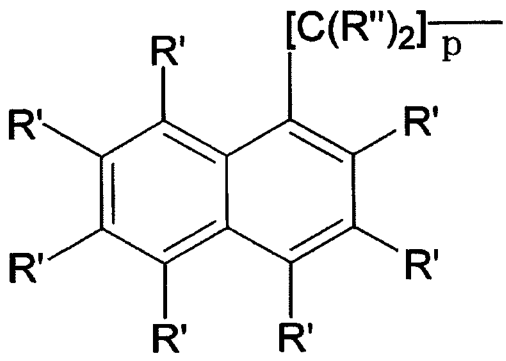

(9)

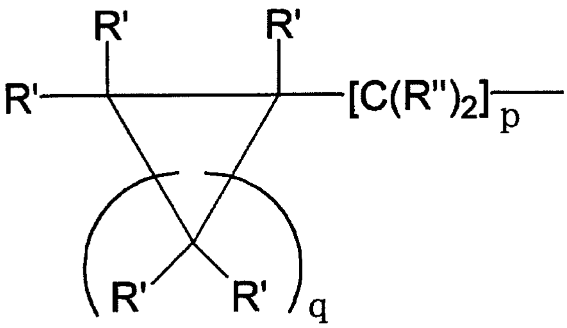

(10)

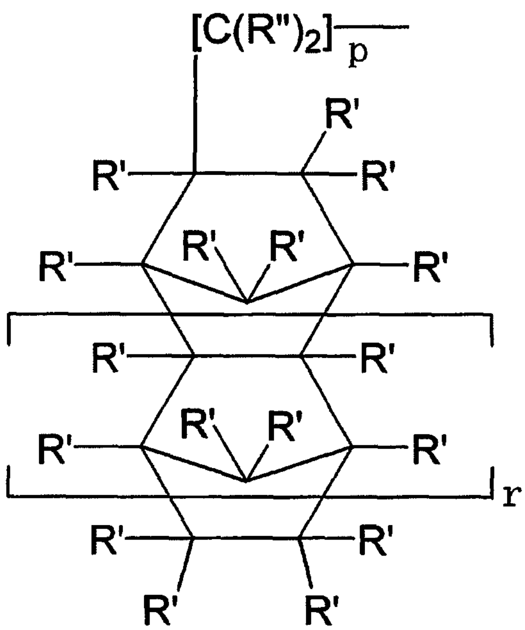

(11)

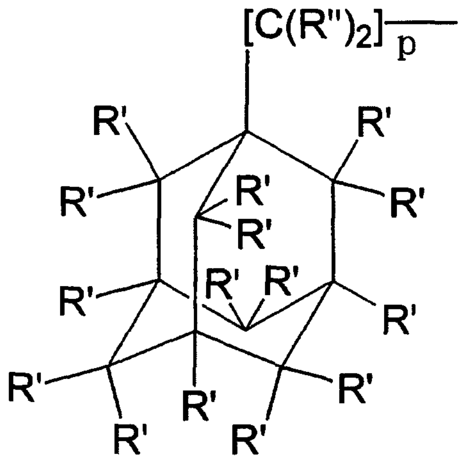

(12)

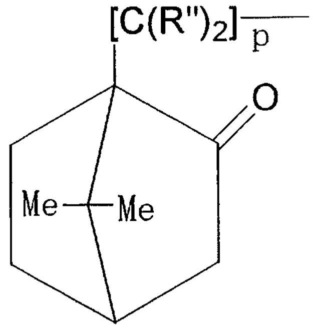

(13)

In the formulas (7) to (13), R' individually represents a hydrogen atom, halogen atom, hydroxyl group, acetyl group, carboxyl group, nitro group, cyano group, primary amino group, secondary amino group, linear or branched alkoxyl group having 1 to 10 carbon atoms, linear or branched alkyl group having 1 to 10 carbon atoms, or linear or branched fluoroalkyl group having 1 to 10 carbon atoms, R" individually represents a hydrogen atom, halogen atom, linear or branched alkyl group having 1 to 10 carbon atoms, or a linear or branched fluoroalkyl group having 1 to 10 carbon atoms, p is an integer of 0 to 10, and Me is a methyl group.

In the formula (10), q is an integer of 1 to 18.

In the formula (11), r is an integer of 0 to 3.

As preferable examples of the acids (3) in the present invention, trifluoromethanesulfonic acid, pentafluoroethanesulfonic acid, heptafluoro-n-propanesulfonic acid, nonafluoro-n-butanesulfonic acid, perfluoro-n-octanesulfonic acid, 1,1,2,2,-tetrafluoro-n-propanesulfonic acid, 1,1,2,2,-tetrafluoro-n-butanesulfonic acid, and 1,1,2,2-tetrafluoro-n-octanesulfonic acid, as well as acids obtainable by bonding a group $-CF_2CF_2SO_3H$, $-CF_2CF(CF_3)SO_3H$, $-CF(CF_3)CF_2SO_3H$, $-CF(CF_3)CF(CF_3)SO_3H$, $-C(CF_3)_2CF_2SO_3H$, or $-CF_2C(CF_3)_2SO_3H$ to the bonding site of the group of any of the above formulas (7)-(13), for example, the acids of the following formulas (3-1) to (3-10) can be given.

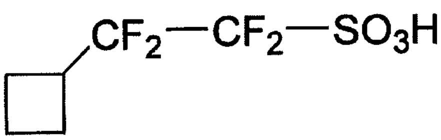

(3-1)

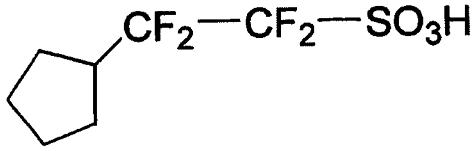

(3-2)

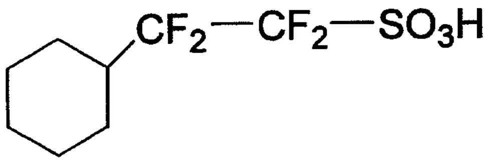

(3-3)

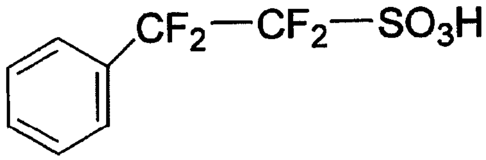

(3-4)

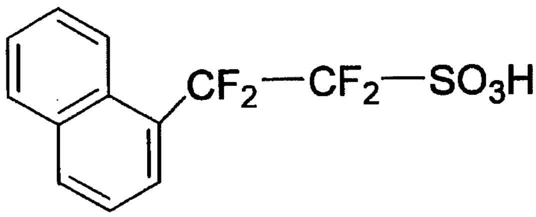

(3-5)

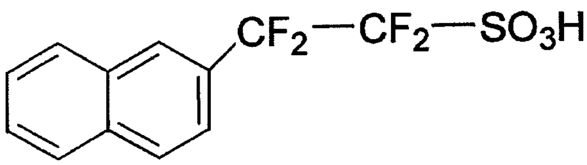

(3-6)

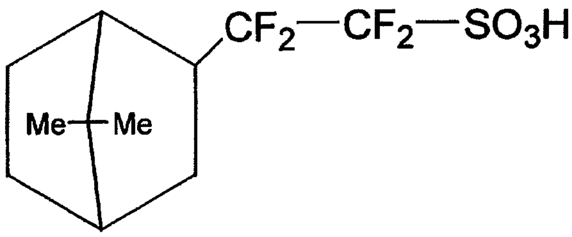

(3-7)

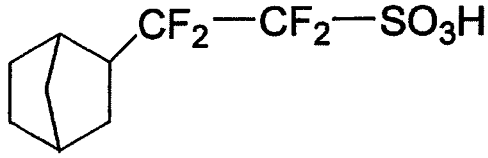

(3-8)

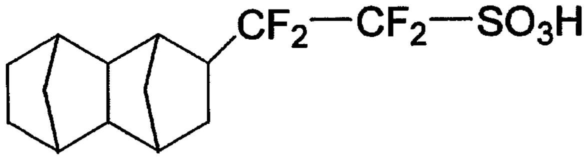

(3-9)

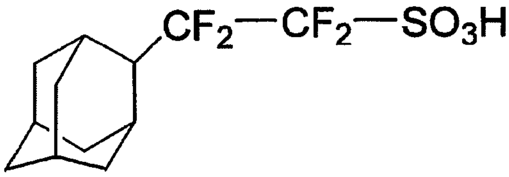

(3-10)

As preferable examples of the acids (4) in the present invention, 1-fluoroethanesulfonic acid, 1-fluoro-n-propanesulfonic acid, 1-fluoro-n-butanesulfonic acid, 1-fluoro-n-octanesulfonic acid, 1,1-difluoroethanesulfonic acid, 1,1-difluoro-n-propanesulfonic acid, 1,1-difluoro-n-butanesulfonic acid, 1,1-difluoro-n-octanesulfonic acid, 1-trifluoromethyl-n-propanesulfonic acid, 1-trifluoromethyl-n-butanesulfonic acid, 1-trifluoromethyl-n-octanesulfonic acid, 1,1-bis(trifluoromethyl)ethanesulfonic acid, 1,1-bis(trifluoromethyl)-n-propanesulfonic acid, 1,1-bis(trifluoromethyl)-n-butanesulfonic acid, and 1,1-bis(trifluoromethyl)-n-octanesulfonic acid, as well as acids produced by bonding a group $-CF_2SO_3H$, $-CHFSO_3H$, $-CH(CF_3)SO_3H$, or $-C(CF_3)_2SO_3H$ to the bonding site of the group of any of the above formulas (7)-(13), for example, the acids of the following formulas (4-1) to (4-40) can be given.

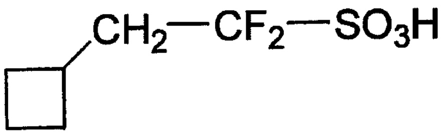

(4-1)

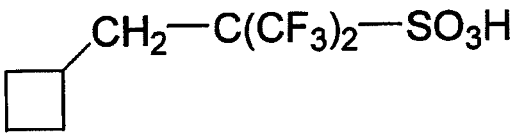

(4-2)

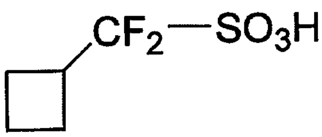

(4-3)

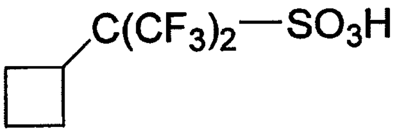

(4-4)

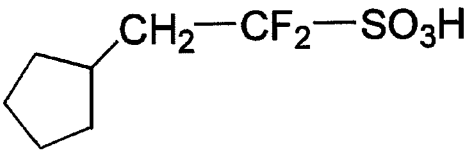

(4-5)

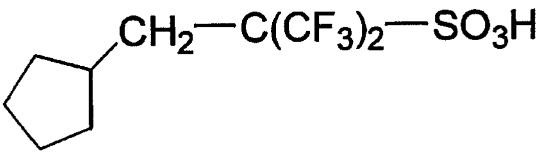

(4-6)

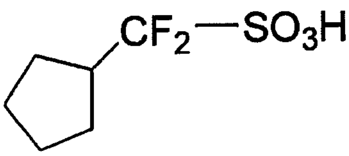

(4-7)

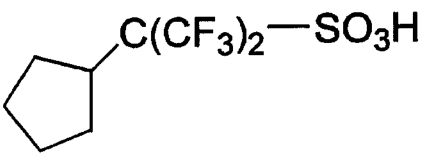

(4-8)

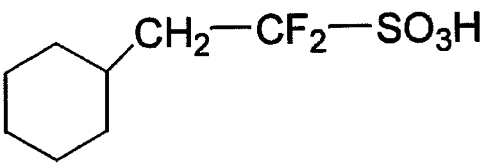

(4-9)

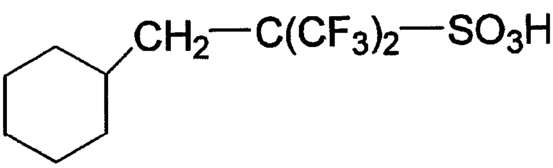

(4-10)

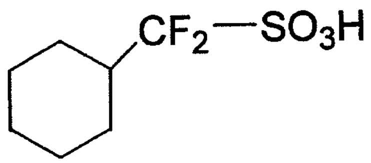

(4-11)

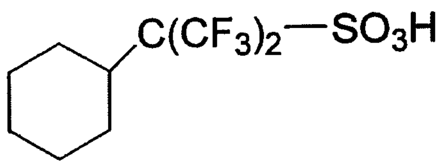

(4-12)

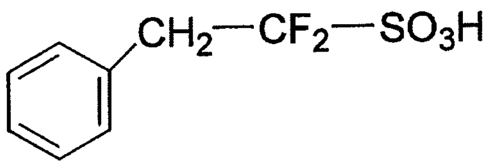

(4-13)

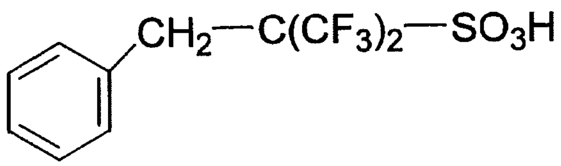

(4-14)

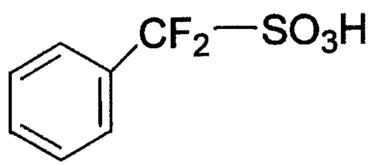

(4-15)

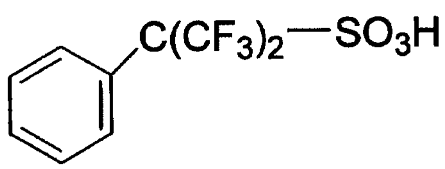

(4-16)

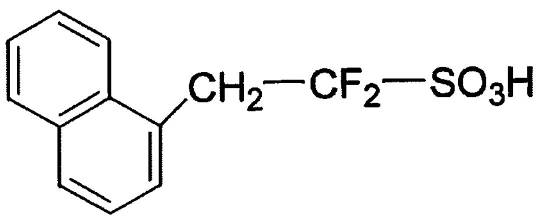

(4-17)

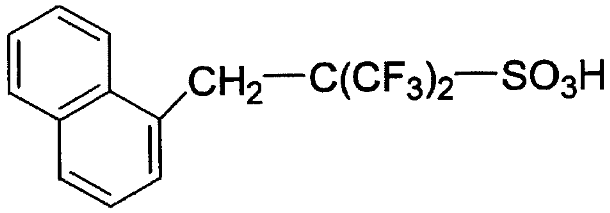

(4-18)

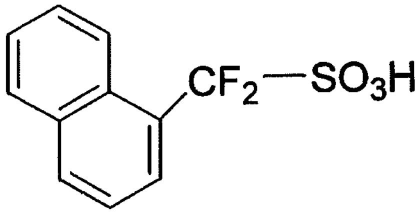

(4-19)

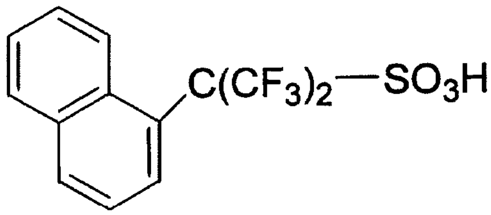

(4-20)

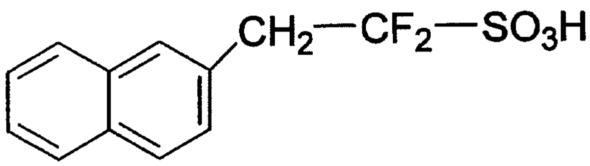

(4-21)

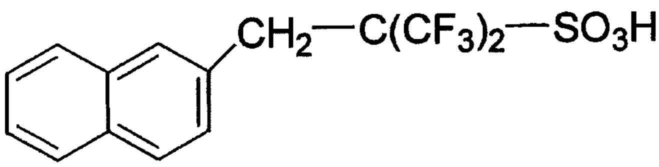

(4-22)

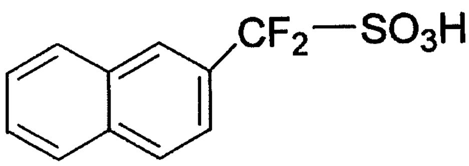

(4-23)

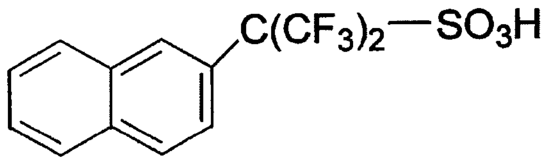
(4-24)

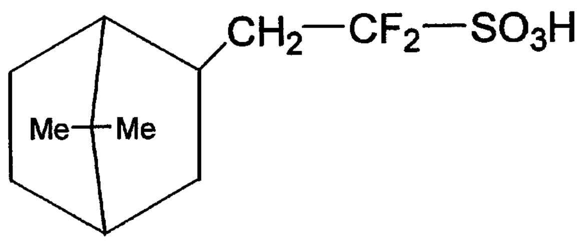
(4-25)

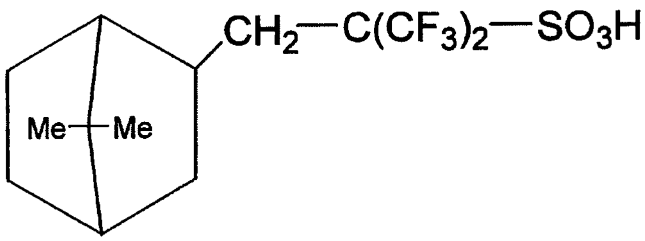
(4-26)

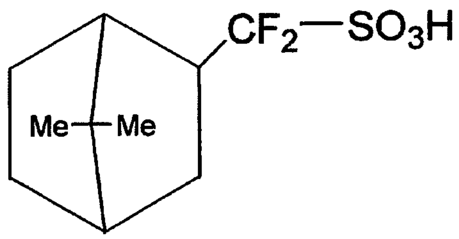
(4-27)

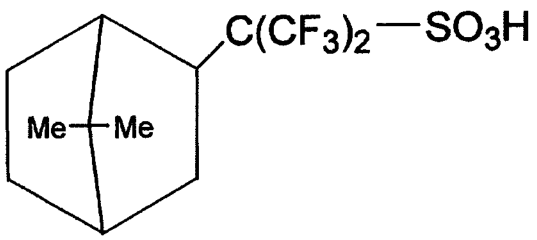
(4-28)

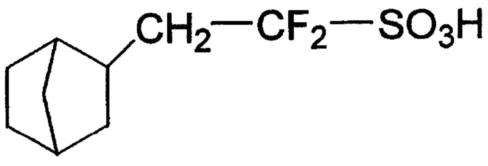
(4-29)

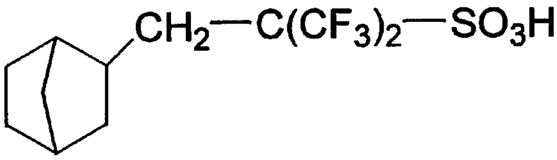

(4-30)

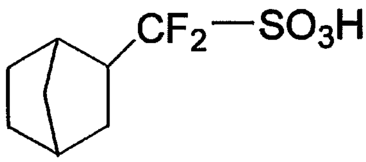

(4-31)

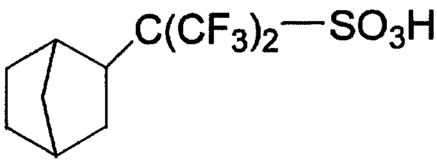

(4-32)

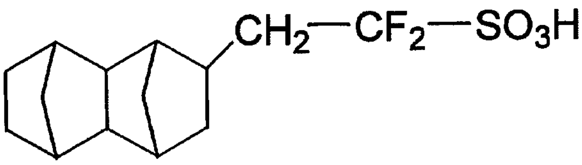

(4-33)

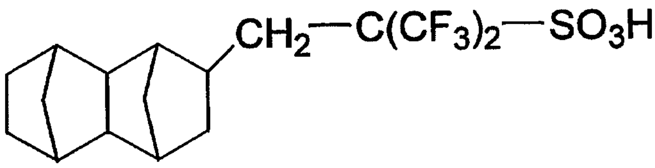

(4-34)

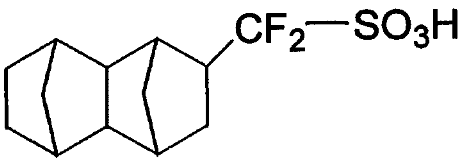

(4-35)

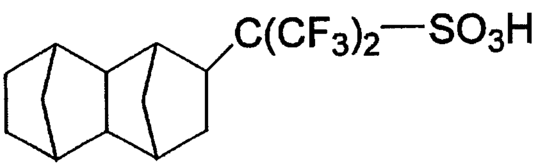

(4-36)

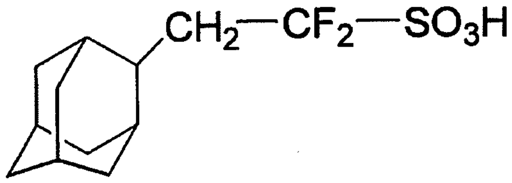

(4-37)

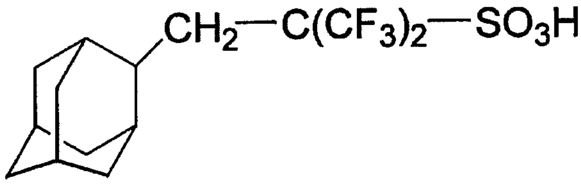

(4-38)

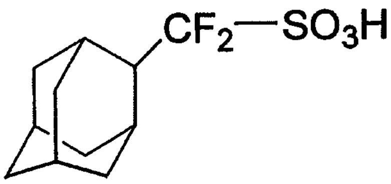

(4-39)

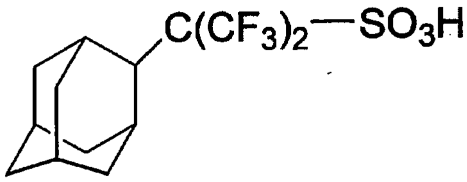

(4-40)

The following acids can be given as preferable examples of the acid (5) in the present invention: linear, branched, or cyclic alkyl sulfonic acids such as methanesulfonic acid, ethanesulfonic acid, n-propanesulfonic acid, n-butanesulfonic acid, i-butanesulfonic acid, sec-butanesulfonic acid, t-butanesulfonic acid, n-pentanesulfonic acid, n-hexanesulfonic acid, n-octanesulfonic acid, cyclopentanesulfonic acid, and cyclohexanesulfonic acid; aromatic sulfonic acids such as benzenesulfonic acid, p-toluenesulfonic acid, benzylsulfonic acid, α-naphthalenesulfonic acid, and β-naphthalenesulfonic acid; and 10-camphorsulfonic acid, as well as acids produced by bonding a group $-SO_3H$ to the bonding site of the group of any of the formulas (7) to (13).

The following acids can be given as preferable examples of the acids (6) in the present invention: acetic acid, n-propionic acid, butyric acid, isobutyric acid, valeric acid, isovaleric acid, caproic acid, benzoic acid, salicylic acid, phthalic acid, terephthalic acid, α-naphthalenecarboxylic acid, β-naphthalenecarboxylic acid, cyclobutanecarboxylic acid, cyclopentanecarboxylic acid, cyclohexanecarboxylic acid, 1,1-cyclobutanedicarboxylic acid, 1,2-cyclobutanedicarboxylic acid, 1,1-cyclopentanedicarboxylic acid, 1,2-cyclopentanedicarboxylic acid, 1,3-cyclopentanedicarboxylic acid, 1,1-cyclohexanedicarboxylic acid, 1,2-cyclohexanedicarboxylic acid, 1,3-cyclohexanedicarboxylic acid, 1,4-cyclohexanedicarboxylic acid, 2-norbornanecarboxylic acid, 2,3-norbornanedicarboxylic acid, norbornyl-2-acetic acid, 1-adamantanecarboxylic acid, 1-adamantaneacetic acid, 1,3-adamantanedicarboxylic acid, 1,3-adamantanediacetic acid, lithocholic acid, deoxycholic acid, chenodeoxycholic acid, and cholic acid, as well as acids produced by bonding a group -COOH to the bonding site of the group of any of the formulas (7) to (13).

As examples of the onium salt compounds generating the acid (3), acid (4), acid (5), or acid (6), a diphenyliodonium salt, bis(4-t-butylphenyl)iodonium salt, triphenylsulfonium salt, 4-hydroxyphenyl·phenyl·methylsulfonium salt, cyclohexyl·2-oxocyclohexyl·methylsulfonium salt, dicyclohexyl·2-oxocyclohexylsulfonium salt, 2-oxocyclohexyldimethylsulfonium salt, 4-hydroxyphenyl·benzyl·methylsulfonium salt, 1-naphthyldimethylsulfonium salt, 1-naphthyldiethylsulfonium salt, 4-cyano-1-naphthyldimethylsulfonium salt, 4-cyano-1-naphthyldiethylsulfonium salt, 4-nitro-1-naphthyldimethylsulfonium salt, 4-nitro-1-naphthyldiethylsulfonium salt, 4-methyl-1-naphthyldimethylsulfonium salt, 4-methyl-1-naphthyldiethylsulfonium salt, 4-hydroxy-1-naphthyldimethylsulfonium salt, 4-hydroxy-1-naphthyldiethylsulfonium salt, 1-(4-hydroxynaphthalen-1-yl)tetrahydrothiophenium salt, 1-(4-methoxynaphthalen-1-yl)tetrahydrothiophenium salt,

1-(4-ethoxynaphthalen-1-yl)tetrahydrothiophenium salt, 1-(4-n-butoxynaphthalen-1-yl)tetrahydrothiophenium salt, 1-(4-methoxymethoxynaphthalen-1-yl)tetrahydrothiophenium salt, 1-(4-ethoxymethoxynaphthalen-1-yl)tetrahydrothiophenium salt, 1-[4-(1-methoxyethoxy)naphthalen-1-yl]tetrahydrothiophenium salt, 1-[4-(2-methoxyethoxy)naphthalen-1-yl] tetrahydrothiophenium salt, 1-(4-methoxycarbonyloxynaphthalen-1-yl)tetrahydrothiophenium salt, 1-(4-ethoxycarbonyloxynaphthalen-1-yl)tetrahydrothiophenium salt, 1-(4-n-propoxycarbonyloxynaphthalen-1-yl)tetrahydrothiophenium salt, 1-(4-i-propoxycarbonyloxynaphthalen-1-yl)tetrahydrothiophenium salt, 1-(4-n-butoxycarbonyloxynaphthalen-1-yl) tetrahydrothiophenium salt, 1-(4-t-butoxycarbonyloxynaphthalen-1-yl)tetrahydrothiophenium salt, 1-[4-(2-tetrahydrofuranyloxy)naphthalen-1-yl]tetrahydrothiophenium salt, 1-[4-(2-tetrahydropyranyloxy)naphthalen-1-yl]tetrahydrothiophenium salt, 1-(4-benzyloxynaphthalen-1-yl)tetrahydrothiophenium salt, and 1-[1-(1-naphthylacetomethyl)]tetrahydrothiophenium salt; and the like can be given.

As examples of sulfone compounds generating the acid (3), acid (4), or acid (5), β-ketosulfone, β-sulfonylsulfone, and α-diazo compounds of these compounds can be given.

As examples of the sulfonic acid compounds generating the acid (3), acid (4), or acid (5), sulfonic acid esters, sulfonic acid imides, arylsulfonic acid esters, and iminosulfonates can be given.

As examples of carboxylic acid compounds generating the acid (6), carboxylic acid ester, carboxylic acid imide, and carboxylic acid cyanate can be given.

As examples of the diazoketone compounds generating the acid (3), acid (4), acid (5), or acid (6), 1,3-diketo-2-diazo compounds, diazobenzoquinone compounds, and diazonaphthoquinone compounds can be given.

As examples of halogen-containing compounds generating the acid (3), acid (4), acid (5), or acid (6), haloalkyl group-containing hydrocarbon compounds and haloalkyl group-containing heterocyclic compounds can be given.

The blend ratio of the acid generator (B1) and the acid generator (B2) in the present invention is preferably from 100:0 to 100:150 (by weight).

In addition, as preferable examples of the acid generator (B) other than the acid generator (B1) and the acid generator (B2) (hereinafter referred to as "the other acid generator (B)"), other onium salt compounds such as diphenyliodonium pyrenesulfonate, diphenyliodonium n-dodecylbenzenesulfonate, diphenyliodonium hexafluoroantimonate, bis(4-t-butylphenyl)iodonium n-dodecylbenzenesulfonate, bis(4-t-butylphenyl)iodonium hexafluoroantimonate, bis(4-t-butylphenyl)iodonium naphthalenesulfonate, triphenylsulfonium hexafluoroantimonate, triphenylsulfonium naphthalenesulfonate, triphenylsulfonium 10-camphorsulfonate, 4-hydroxyphenyl·phenyl·methylsulfonium p-toluenesulfonate, and 4-hydroxyphenyl·benzyl·methylsulfonium p-toluenesulfonate; other sulfone compounds such as 4-trisphenacylsulfone, mesitylphenacylsulfone, and bis(phenylsulfonyl)methane; other sulfonic acid compounds such as benzoin tosylate and nitrobenzyl 9,10-diethoxyanthracene-2-sulfonate; other diazoketone compounds such as 1,2-naphthoquinonediazido-4-sulfonyl chloride, 1,2-naphthoquinonediazido-5-sulfonyl chloride, 1,2-naphthoquinonediazido-4-sulfonate or 1,2-naphthoquinonediazido-5-sulfonate of 2,3,4,4'-tetrahydroxybenzophenone, and 1,2-naphthoquinonediazido-4-sulfonate or 1,2-naphthoquinonediazido-5-sulfonate of 1,1,1-tris(4-hydroxyphenyl)ethane; and other halogen-containing compounds such as (trichloromethyl)-s-triazine derivatives such as phenylbis(trichloromethyl)-s-triazine, 4-methoxyphenylbis(trichloromethyl)-s-triazine, and 1-naphthylbis(trichloromethyl)-s-triazine, and 1,1-bis(4-chlorophenyl)-2,2,2-trichloroethane; a disulfonyldiazomethane compound of the following formula (14),

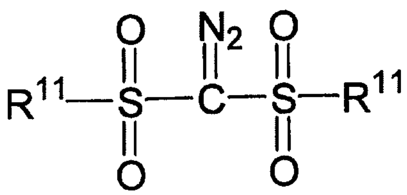

(14)

wherein $R^{11}$ individually represents a monovalent group such as an alkyl group, aryl group, halogenated alkyl group, and halogenated aryl group; oxime sulfonate compounds of the following formulas (15-1) or (15-2),

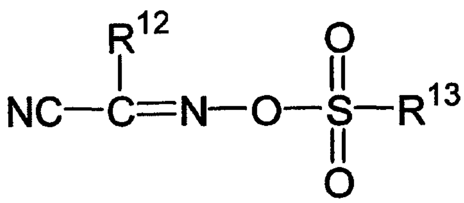

(15-1)

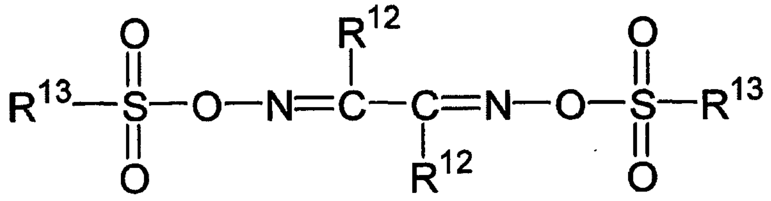

(15-2)

wherein $R^{12}$ and $R^{13}$ individually represent a monovalent organic group; and the like can be given.

As specific examples of the disulfonyldiazomethane compound, bis(trifluoromethanesulfonyl)diazomethane, bis(cyclohexanesulfonyl)diazomethane, bis(benzenesulfonyl)diazomethane, bis(p-toluenesulfonyl)diazomethane, methanesulfonyl-p-toluenesulfonyldiazomethane, cyclohexanesulfonyl-1,1-dimethylethylsulfonyldiazomethane, bis (1,1-dimethylethanesulfonyl)diazomethane, bis(3,3-dimethyl-1,5-dioxaspiro[5.5]dodecane-8-sulfonyl)diazomethane, and bis(1,4-dioxaspiro[4.5]decane-7-sulfonyl)diazomethane can be given.

As specific examples of $R^{12}$ in the formulas (15-1) and (15-2), a methyl group, ethyl group, n-propyl group, phenyl group, tosyl group, trifluoromethyl group, and nonafluoro-n-butyl group can be given.

As specific examples of $R^{13}$, a phenyl group, tosyl group, and naphthyl group can be given.

As other preferable examples of the other acid generators (B), sulfonates, such as trifluoromethanesulfonate, nonafluoro-n-butanesulfonate, perfluoro-n-octanesulfonate, benzenesulfonate, p-toluenesulfonate, methanesulfonate, and n-butanesulfonate of the following oxime compounds can be given.

As examples of the oxime compound which can be used, the following can be given: 2,2-difluoro-2-methylacetophenone-O-methylsulfonyloxime, 2,2-dichloro-2-methoxymethyl-2'-methylacetophenone-O-(n-propyl)sulfonyloxime, 2,2-difluoro-2-ethylacetophenone-O-(n-propyl)sulfonyloxime, 2,2-difluoro-2-phenylacetophenone-O-ethylsulfonyloxime, 2-chloro-2-fluoro-2-cyclohexylacetophenone-O-(p-tolyl)sulfonyloxime, 2,2-difluoro-2-(n-propyl)acetophenone-O-(10-camphor)sulfonyloxime, 2,2-difluoro-2-methyl-4'-methoxyacetophenone-O-(n-propyl)sulfonyloxime, 2,2-difluoro-2-methylacetonaphthone-O-trifluoromethylsulfonyloxime, 1,1-difluoro-1-phenylacetone-O-(n-butyl)sulfonyloxime, (1, 1-difluoro-1-cyclohexyl)methyl-2'-thienylketone-O-methylsulfonyloxime, (1,1-dichloro-1-phenyl)methyl-2'-furylketone-O-(n-propyl)sulfonyloxime, 2,2-difluoro-2-methylcarbonylacetophenone-O-methylsulfonyloxime, 2,2-dichloro-2-methoxymethylcarbonyl-2'-methylacetophenone-O-(n-propyl) sulfonyloxime, 2,2-difluoro-2-ethylcarbonylacetophenone-O-(n-propyl)sulfonyloxime, 2,2-difluoro-2-phenylcarbonylacetophenone-O-ethylsulfonyloxime, 2-chloro-2-fluoro-2-cyclohexylcarbonylacetophenone-O-(p-tolyl)sulfonyloxime, 2,2-difluoro-2-(n-propylcarbonyl)acetophenone-O-(10-camphor)sulfonyloxime, 2,2-difluoro-2-methylcarbonyl-4'-methoxyacetophenone-O-(n-propyl)sulfonyloxime, 2,2-difluoro-2-methylcarbonylacetonaphthone-O-trifluoromethylsulfonyloxime, 1, 1-difluoro-1-phenylcarbonylacetone-O-(n-butyl)sulfonyloxime, (1, 1-difluoro-1-cyclohexylcarbonyl)methyl-2'-thienylketone-O-methylsulfonyloxime, (1,1-dichloro-1-phenylcarbonyl)methyl-2'-furylketone-O-(n-propyl)sulfonyloxime, 2,2-difluoro-2-methoxycarbonylacetophenone-O-methylsulfonyloxime, 2,2-difluoro-2-ethoxycarbonylacetophenone-O-(n-propyl)sulfonyloxime, 2,2-difluoro-2-phenoxycarbonylacetophenone-O-ethylsulfonyloxime, 2-chloro-2-fluoro-2-cyclohexyloxycarbonylacetophenone-O-(p-tolyl)sulfonyloxime, 2,2-difluoro-2-(n-propoxycarbonyl)acetophenone-O-(10-camphor)sulfonyloxime, 2,2-difluoro-2-methoxycarbonyl-4'-methoxyacetophenone-O-(n-propyl)sulfonyloxime, 2,2-difluoro-2-methoxycarbonylacetonaphthone-O-trifluoromethylsulfonyloxime, 1, 1-difluoro-1-phenoxycarbonylacetone-O-(n-butyl)sulfonyloxime, (1, 1-dichloro-1-cyclohexyloxycarbonyl)methyl-2'-thienylketone-O-methylsulfonyl oxime, (1, 1-difluoro-1-phenoxycarbonyl)methyl-2'-furylketone-O-(n-propyl)sulfonyloxime, 2,2-difluoro-2-(N,N-dimethylamide)acetophenone-O-methylsulfonyloxime, 2,2-difluoro-2-(N-ethylamide)-2'-methyl-acetophenone-O-(n-propyl)sulfonyloxime, 2,2-difluoro-2-(N-phenylamide)acetophenone-O-ethylsulfonyloxime, 2-chloro-2-fluoro-2-(N-methyl-N-cyclohexylamide)acetophenone-O-(p-tolyl)sulfonyl oxime, 2,2-difluoro-2-(n-propylamide)acetophenone-O-(10-camphor)sulfonyloxime, 2,2-difluoro-2-(N-methyl-N-cyclohexylamide)-4'-methoxyacetophenone-O-(n-propyl) sulfonyloxime, 2,2-difluoro-2-(N,N-dimethylamide)acetonaphthone-O-trifluoromethylsulfonyloxime, 1,1-difluoro-1-(N-phenylamide)acetone-O-(n-butyl)sulfonyloxime, [1,1-difluoro-1-(N-cyclohexylamide)]methyl-2'-thienylketone-O-methylsulfonyloxime, (1,1-dichloro-1-(N-phenylamide))methyl-2'-furylketone-O-(n-propyl)sulfonyloxime, 2,2-difluoro-2-thiomethoxyacetophenone-O-methylsulfonyloxime, 2,2-difluoro-2-thioethoxyacetophenone-O-(n-propyl)sulfonyloxime, 2,2-difluoro-2-thiophenoxyacetophenone-O-ethylsulfonyloxime, 2-chloro-2-fluoro-2-thiocyclohexyloxyacetophenone-O-(p-tolyl)sulfonyloxime, 2,2-difluoro-2-thiomethoxy-4'-methoxyacetophenone-O-(n-propyl) sulfonyloxime, 2,2-difluoro-2-thiomethoxyacetonaphthone-O-trifluoromethylsulfonyloxime, 1,1-difluoro-1-thiophenoxyacetone-O-(n-butyl)sulfonyloxime, (1, 1-difluoro-1-thiocyclohexyloxy)methyl-2'-thienylketone-O-methylsulfonyloxime, (1,1-dichloro-1-thiophenoxy)methyl-2'-furylketone-O-(n-propyl)sulfonyloxime, 2,2-difluoro-2-methylsulfinylacetophenone-O-methylsulfonyloxime, 2,2-difluoro-2-ethylsulfinylacetophenone-O-(n-propyl)sulfonyloxime, 2,2-difluoro-2-phenylsulfinylacetophenone-O-ethylsulfonyloxime, 2-chloro-2-fluoro-2-cyclohexylsulfinylacetophenone-O-(p-tolyl)sulfonyloxime, 2,2-difluoro-2-(n-propylsulfinyl)acetophenone-O-(10-camphor)sulfonyloxime, 2,2-difluoro-2-methylsulfinyl-4'-methoxyacetophenone-O-(n-propyl)sulfonyloxime, 2,2-difluoro-2-methylsulfinylacetonaphthone-O-trifluoromethylsulfonyloxime, 1,1-difluoro-1-phenylsulfinylacetone-O-(n-butyl)sulfonyloxime, (1, 1-difluoro-1-cyclohexylsulfinyl)methyl-2'-thienylketone-O-methylsulfonyloxime, (1,1-dichloro-1-phenylsulfinyl)methyl-2'-furylketone-O-(n-propyl)sulfonyloxime, 2,2-difluoro-2-phenylsulfonylacetophenone-O-(n-propyl)sulfonyloxime, 2,2-difluoro-2-phenylsulfonylacetophenone-O-methylsulfonyloxime, 2,2-difluoro-2-phenylsulfonylacetophenone-O-ethylsulfonyloxime, 2,2-dichloro-2-phenylsulfonylacetophenone-O-methylsulfonyloxime, 2,2-difluoro-2-phenylsulfonylacetophenone-O-(10-camphor)sulfonyloxime, 2,2-difluoro-2-phenylsulfonylacetophenone-O-(p-tolyl)sulfonyloxime, 2,2-difluoro-2-phenylsulfonylacetophenone-O-trifluoromethylsulfonyloxime, 2,2-difluoro-2-phenylsulfonyl-4'-methoxyacetophenone-O-(n-propyl)sulfonyloxime, 2,2-difluoro-2-phenylsulfonyl-4'-methoxyacetophenone-O-methylsulfonyloxime, 2,2-difluoro-2-phenylsulfonyl-4'-methoxyacetophenone-O-ethylsulfonyloxime, 2,2-dichloro-2-phenylsulfonyl-4'-methoxyacetophenone-O-methylsulfonyloxime, 2,2-difluoro-2-phenylsulfonyl-4'-methoxyacetophenone-O-(10-camphor)sulfonyloxime, 2,2-difluoro-2-phenylsulfonyl-4'-methoxyacetophenone-O-(p-tolyl)sulfonyloxime, 2,2-difluoro-2-phenylsulfonyl-4'-methoxyacetophenone-O-trifluoromethylsulfonyl oxime, 2,2-difluoro-2-phenylsulfonyl-2'-methylacetophenone-O-(n-propyl)sulfonyloxime, 2,2-difluoro-2-phenylsulfonyl-2'-methylacetophenone-O-methylsulfonyloxime, 2,2-difluoro-2-phenylsulfonyl-2'-methylacetophenone-O-ethylsulfonyloxime, 2,2-dichloro-2-phenylsulfonyl-2'-methylacetophenone-O-methylsulfonyloxime, 2,2-difluoro-2-phenylsulfonyl-2'-methylacetophenone-O-camphorsulfonyloxime, 2,2-difluoro-2-cyclohexylsulfonylacetophenone-O-(n-propyl)sulfonyloxime, 2,2-difluoro-2-cyclohexylsulfonylacetophenone-O-methylsulfonyloxime, 2,2-difluoro-2-cyclohexylsulfonylacetophenone-O-ethylsulfonyloxime, 2,2-dichloro-2-cyclohexylsulfonylacetophenone-O-methylsulfonyloxime, 2,2-difluoro-2-cyclohexylsulfonylacetophenone-O-(10-camphor)sulfonyloxime, 2,2-difluoro-2-cyclohexylsulfonylacetophenone-O-trifluoromethylsulfonyloxime, 2,2-difluoro-2-methylsulfonyl-4'-methoxyacetophenone-O-(n-propyl)sulfonyloxime, 2,2-difluoro-2-methylsulfonyl-4'-methoxyacetophenone-O-methylsulfonyloxime, 2,2-difluoro-2-methylsulfonyl-4'-methoxyacetophenone-O-ethylsulfonyloxime, 2,2-dichloro-2-methylsulfonyl-4'-methoxyacetophenone-O-methylsulfonyloxime, 2,2-difluoro-2-methylsulfonyl-4'-methoxyacetophenone-O-(10-camphor)sulfonyl oxime, 2,2-difluoro-2-methylsulfonyl-4'-methoxyacetophenone-O-trifluoromethylsulfonyl oxime, 2,2-dibromo-2-phenylsulfonylacetophenone-O-(10-camphor)sulfonyloxime, 2-chloro-2-fluoro-2-phenylsulfonylacetophenone-O-ethylsulfonyloxime, 2-chloro-2-fluoro-2-phenylsulfonylacetophenone-O-benzylsulfonyloxime, 2,2-difluoro-2-phenylsulfonylacetophenone-O-(1-naphthyl)sulfonyloxime, 2,2-dichloro-2-methylsulfonylacetophenone-O-(p-bromophenyl)sulfonyloxime, 2,2-difluoro-2-phenylsulfonylacetophenone-O-(2-thienyl)sulfonyloxime, 2,2-difluoro-2-cyclohexylsulfonyl-2'-cyanoacetophenone-O-ethylsulfonyloxime, 2,2-difluoro-2-ethylsulfonylacetophenone-O-(n-propyl)sulfonyloxime, 2,2-difluoro-2-(n-propylsulfonyl)acetophenone-O-(10-camphor)sulfonyloxime, 2,2-difluoro-2-methylsulfonylacetonaphthone-O-trifluoromethylsulfonyloxime, 1,1-difluoro-1-phenylacetone-O-(n-butyl)sulfonyloxime, (1, 1-difluoro-1-cyclohexyl)methylsulfonyl-2'-thienylketone-O-methylsulfonyloxime, (1, 1-dichloro-1-phenyl)methylsulfonyl-2'-furylketone-O-(n-propyl)sulfonyloxime, 2,2-difluoro-2-cyanoacetophenone-O-methylsulfonyloxime, 2,2-dichloro-2-cyano-2'-methylacetophenone-O-(n-propyl)sulfonyloxime, 2,2-difluoro-2-cyanoacetophenone-O-ethylsulfonyloxime, 2-chloro-2-fluoro-2-cyanoacetophenone-O-(p-tolyl)sulfonyloxime, 2,2-difluoro-2-cyanoacetophenone-O-(10-camphor)sulfonyloxime, 2,2-difluoro-2-cyano-4'-methoxyacetophenone-O-(n-propyl)sulfonyloxime, 2,2-difluoro-2-cyanoacetonaphthone-O-trifluoromethylsulfonyloxime, 1,1-difluoro-1-cyanoacetone-O-(n-butyl)sulfonyloxime, (1, 1-difluoro-1-cyano)methyl-2'-thienylketone-O-methylsulfonyloxime, (1, 1-dichloro-1-cyano)methyl-2'-furylketone-O-(n-propyl)sulfonyloxime, 2,2-difluoro-2-nitroacetophenone-O-methylsulfonyloxime, 2,2-dichloro-2-nitro-2'-methylacetophenone-O-(n-propyl)sulfonyloxime, 2,2-difluoro-2-nitroacetophenone-O-ethylsulfonyloxime, 2-chloro-2-fluoro-2-nitroacetophenone-O-(p-tolyl)sulfonyloxime, 2,2-difluoro-2-nitroacetophenone-O-(10-camphor)sulfonyloxime, 2,2-difluoro-2-nitro-4'-methoxyacetophenone-O-(n-propyl)sulfonyloxime, 2,2-difluoro-2-nitroacetonaphthone-O-trifluoromethylsulfonyloxime, 1,1-difluoro-1-nitroacetone-O-(n-butyl)sulfonyloxime, (1,1-difluoro-1-nitro)methyl-2'-thienylketone-O-methylsulfonyloxime, (1,1-dichloro-1-nitro)methyl-2'-furylketone-O-(n-propyl)sulfonyloxime, 2,2-dioxo-5-phenylsulfonyldifluoromethyl-3H,4H-1,2,5-oxathioazine, 2,2-dioxo-4,4-difluoro-5-phenyl-3H-1,2,5-oxathioazine, 1,1-dioxo-2,2-difluoro-3-(n-propylsulfonyloxyimino)thiain, 2,2-difluoro-1,3-di(phenylsulfonyl)-1,3-propanedial-O-(n-propylsulfonyl)dioxime, 1,1,5,5-tetrafluoro-1,5-di(methylsulfonyl)-2,4-pentanedione-O,O-di(methylsulfonyl) dioxime, bis(2',2'-difluoro-2'-cyanoacetophenoneoxime)-O-1,4-benzenesulfonic acid, 1,4-bis[1'-(n-propylsulfonyloxyimino)-2',2'-difluoro-2'-(methylsulfonyl)ethyl]benzene, 1,1,4,4-tetrafluoro-1,4-di(methylsulfonyl)-2,3-butanedione-O,O-di(methylsulfonyl) dioxime.

In the present invention, although the other acid generator (B) can be used alone as the acid generator (B), combined use of the other acid generator with the acid generator (B1) or further with the acid generator (B2) is also preferable.

The acid generator (B) may be used either individually or in combination of two or more.

The amount of the acid generator (B) is usually 0.1-30 parts by weight, and preferably 0.5-20 parts by weight for 100 parts by weight of the total resin components from the viewpoint of ensuring sensitivity and developability as a resist. If the amount of the acid generator (B) is less than 0.1 part by weight, sensitivity and developability tend to decrease. If the amount exceeds 30 parts by weight, a rectangular resist pattern may not be obtained due to decreased radiation transmittance.

(C) Solvents

Any solvent capable of dissolving the siloxane resin (A), acid generator (B), and additives that are optionally incorporated and having a moderate volatility can be used as a solvent of component (C) of the present invention without any specific limitations.

As the solvent which can be used, the following solvents can be given: linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; fluorine-containing solvents such as fluorine-containing alcohols such as 2,3-difluorobenzyl alcohol, 2,2,2-trifluoroethanol, 1,3-difluoro-2-propanol, 1,1,1-trifluoro-2-propanol, 3,3,3-trifluoro-1-propanol, 2,2,3,3,4,4,4-heptafluoro-1-butanol, 2,2,3,3,4,4,5,5-octafluoro-1-pentanol, 3,3,4,4,5,5,5-heptafluoro-2-pentanol, 1H,1H-perfluoro-1-octanol, 1H,1H,2H,2H-perfluoro-1-octanol, 1H,1H,9H-perfluoro-1-nonanol, 1H,1H,2H,3H,3H-perfluorononane-1,2-diol, 1H,1H,2H,2H-perfluoro-1-decanol, and 1H,1H,2H,3H,3H-perfluoroundecane-1,2-diol; fluorine-containing esters such as 2,2,2-trifluoroethyl butyrate, ethyl heptafluorobutyrate, ethyl heptafluorobutylacetate, ethyl hexafluoroglutarate, ethyl 3-hydroxy-4,4,4-trifluorobutyrate, ethyl 2-methyl-4,4,4-trifluoroacetoacetate, ethyl pentafluorobenzoate, ethyl pentafluoropropionate, ethyl pentafluoropropionate, ethyl perfluorooctanoate, ethyl 4,4,4-trifluoroacetoacetate, ethyl 4,4,4-trifluorobutyrate, ethyl 4,4,4-trifluorocrotonate, ethyl trifluorosulfonate, ethyl 3-(trifluoromethyl)butyrate, ethyl trifluoropyruvate, ethyl trifluoroacetate, isopropyl 4,4,4-trifluoroacetoacetate, methyl perfluorodecanoate, methyl perfluoro(2-methyl-3-oxahexanoate), methyl perfluorononanoate, methyl perfluorooctanoate, methyl 2,3,3,3-tetrafluoropropionate, methyl trifluoroacetoacetate, methyl trifluoroacetoacetate, methyl perfluoro(2,5,8-trimethyl-3,6,9-trioxadodecanoate), propylene glycol trifluoromethyl ether acetate, propylene glycol methyl ether trifluoromethylacetate, n-butyl trifluoromethylacetate, methyl 3-trifluoromethoxypropionate, 1,1,1-trifluoro-2-propyl acetate, and n-butyl trifluoroacetate; fluorine-containing ethers such as 2-fluoroanisole, 3-fluoroanisole, 4-fluoroanisole, 2,3-difluoroanisole, 2,4-difluoroanisole, 2,5-difluoroanisole, 5,8-difluoro-1,4-benzodioxane, trifluoroacetaldehydeethylhemiacetal, 2H-perfluoro(5-methyl-3,6-dioxanonane), 2H-perfluoro(5,8,11,14-tetramethyl-3,6,9,12,15-pentaoxaoctadecane), (perfluoro-n-butyl)tetrahydrofuran, perfluoro(n-butyltetrahydrofuran), and propylene glycol trifluoromethyl ether; fluorine-containing ketones such as 2,4-difluoropropiophenone, fluorocyclohexane, 1,1,1,2,2,3,3-heptafluoro-7,7-dimethyl-4,6-octanedione, 1,1,1,3,5,5,5-heptafluoropentane-2,4-dione, 3,3,4,4,5,5,5-heptafluoro-2-pentanone, 1,1,1,2,2,6,6,6-octafluoro-2,4-hexanedione, trifluorobutanol-1,1,1-trifluoro-5-methyl-2,4-hexanedione, and perfluorocyclohexanone; fluorine-containing amines such as trifluoroacetamide, perfluorotributylamine, perfluorotrihexylamine, perfluorotripentylamine, and perfluorotripropylamine; and fluorine-substituted cyclic hydrocarbons such as 2,4-difluorotoluene, perfluorodecalin, perfluoro(1,2-dimethylcyclohexane), and perfluoro(1,3-dimethylcyclohexane); n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, ethyl pyruvate, N-methylpyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, $\gamma$-butyrolactone, ethylene carbonate, and propylene carbonate.

These solvents may be used either individually or in combination of two or more. Among these solvents, linear or branched ketones, cyclic ketones, propylene glycol monoalkyl ether acetates, alkyl 2-hydroxypropionates, alkyl 3-alkoxypropionates, and fluorine-containing solvents are preferable.

The total solid component concentration of the radiation-sensitive resin composition of the present invention is usually from 1 to 25 wt%, and preferably from 2 to 15 wt%. The compostion is usually used after filtering through a filter with a pore size of about 0.2 $\mu$m, for example.

Additives

Additives such as a dissolution controller, a surfactant, and the like may be added to the radiation-sensitive resin composition of the present invention.

As examples of preferable dissolution controllers, a compound shown by the following formula (16) (hereinafter referred to as "dissolution controller (D1)"), a compound shown by the following formula (17) (hereinafter referred to as "dissolution controller (D2)"), a polyketone having a recurring unit shown by the following formula (19) (hereinafter referred to as "dissolution controller (D3)"), a polyspiroketal having a recurring unit shown by the following formula (20) (hereinafter referred to as "dissolution controller (D4)"), and the like can be given. At least one of the compounds selected from the dissolution controller (D1) and the dissolution controller (D2) and/or at least one of the compounds selected from the dissolution controller (D3) and the dissolution controller (D4) are more preferable. The addition of such a dissolution controller ensures appropriate control of the dissolution contrast and the dissolution rate of the resist.

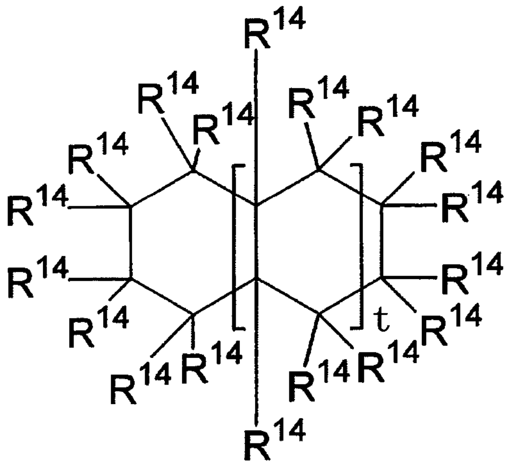

(16)

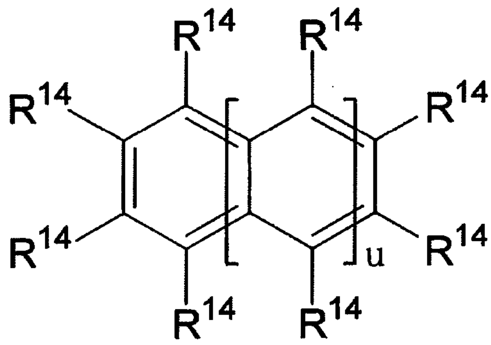

(17)

wherein $R^{14}$ individually represents a hydrogen atom, fluorine atom, linear or branched alkyl group having 1 to 10 carbon atoms, linear or branched fluoroalkyl group having 1 to 10 carbon atoms, or a group of the following formula (18), provided that at least one of the groups $R^{14}$ is the group of the formula (18), and t and u are individually an integer from 0 to 2;

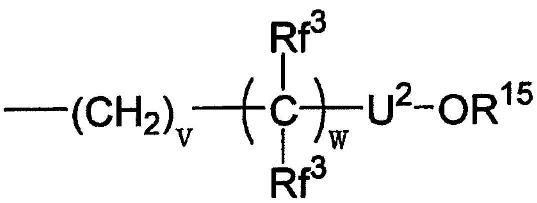

(18)

wherein $Rf^3$ individually represents a hydrogen atom, methyl group, or trifluoromethyl group, $U^2$ is a single bond, methylene group, cyclohexylene group, or phenylene group, $R^{15}$ represents a hydrogen atom or a monovalent organic group dissociating with an acid to produce a hydrogen atom, v is an integer of 0 to 3, and w is 0 or 1.

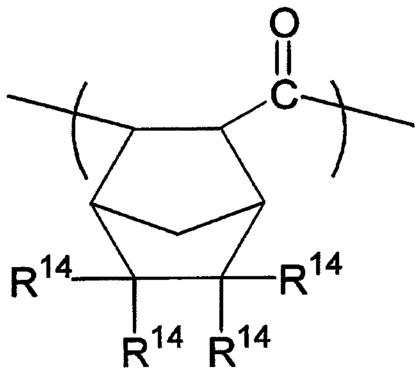

(19)

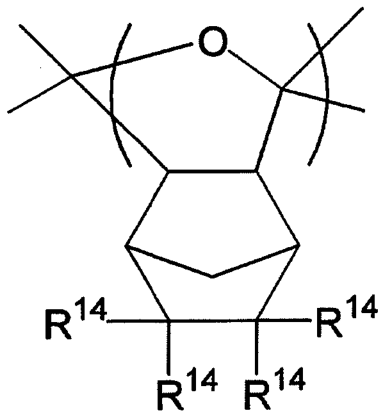

(20)

wherein $R^{14}$ is the same as defined for the above formulas (16) and (17).

As examples of the linear or branched alkyl group having 1 to 10 carbon atoms represented by $R^{14}$ in the formula (16), (17), (19), or (20), a methyl group, ethyl group, n-propyl group, i-propyl group, n-butyl group, i-butyl group, sec-butyl group, t-butyl group, n-pentyl group, n-hexyl group, n-heptyl group, n-octyl group, n-nonyl group, and n-decyl group can be given.

As examples of the linear or branched fluoroalkyl group having 1 to 10 carbon atoms represented by $R^{14}$, a fluoromethyl group, difluoromethyl group, trifluoromethyl group, pentafluoroethyl group, heptafluoro- n-propyl group, heptafluoro-i-propyl group, nonafluoro-n-butyl group, perfluoro-n-pentyl group, perfluoro-n-hexyl group, perfluoro-n-heptyl group, perfluoro-n-octyl group, perfluoro-n-nonyl group, and perfluoro-n-decyl group can be given.

The two bonding sites in the cyclohexylene group and phenylene group represented by $U^2$ in the group of the above formula (18) representing the $R^{14}$ group may be 1,2-, 1,3-, or 1,4-positions.

As examples of the monovalent organic group dissociable by the action of an acid to produce hydrogen atoms represented by $R^{15}$: organocarbonyl groups such as a t-butoxycarbonyl group, methoxycarbonyl group, ethoxycarbonyl group, i-propoxycarbonyl group, 9-fluorenylmethylcarbonyl group, 2,2,2-trichloroethylcarbonyl group, 2-(trimethylsilyl) ethylcarbonyl group, i-butylcarbonyl group, vinylcarbonyl group, allylcarbonyl group, benzylcarbonyl group, 4-ethoxy-1-naphthylcarbonyl group, and methyldithiocarbonyl group; alkyl-substituted alicyclic group such as a 1-methylcyclopentyl group, 1-ethylcyclopentyl group, 1-methylcyclohexyl group, 1-ethylcyclohexyl group, 2-methyladamantan-2-yl group, 2-ethyladamantan-2-yl group, 2-methylbicyclo[2.2.1]heptan-2-yl group, and 2-ethylbicyclo[2.2.1]heptan-2-yl group; organic groups bonding to the oxygen atom in the formula (18) to form an acetal structure such as a methoxymethyl group, methylthiomethyl group, ethoxymethyl group, ethylthiomethyl group, t-butoxymethyl group, t-butylthiomethyl group, (phenyldimethylsilyl)methoxymethyl group, benzyloxymethyl group, t-butoxymethyl group, siloxymethyl group, 2-methoxyethoxymethyl group, 2,2,2-trichloroethoxymethyl group, bis(2-chloroethoxy)methyl group, 2-(trimethylsilyl)ethoxymethyl group, 1-methoxycyclohexyl group, tetrahydropyranyl group, 4-methoxytetrahydropyranyl group, tetrahydrofuranyl group, tetrahydrothiopyranyl group, tetrahydrothiofuranyl group, 1-methoxyethyl group, 1-ethoxyethyl group, 1-(2-chloroethoxy)ethyl group, 1-methyl-1-methoxyethyl group, 1-methyl-1-benzyloxyethyl group, 1-(2-chloroethoxy)ethyl group, 1-methyl-1-benzyloxy-2-fluoroethyl group, 2,2,2-trichloroethyl group, 2-trimethylsilylethyl group, and 2-(phenylselenyl) ethyl group; alkylsilyl groups such as a trimethylsilyl group, ethyldimethylsilyl group, triethylsilyl group, i-propyldimethylsilyl group, i-propyldiethylsilyl group, tri-i-propylsilyl group, t-butyldimethylsilyl group, t-butyldiphenylsilyl group, tribenzylsilyl group, tri-p-xylylsilyl group, methyldiphenylsilyl group, triphenylsilyl group, and t-butylmethoxyphenylsilyl group; and the like can be given.

Of these monovalent organic groups dissociable with an acid to produce hydrogen atoms, t-butoxycarbonyl group, methoxymethyl group, ethoxymethyl group, 1-methoxyethyl group, 1-ethoxyethyl group, and the like are preferable.

As preferable examples of the dissolution controller (D1), compounds shown by the following formulas (D1-1) to (D1-4) can be given:

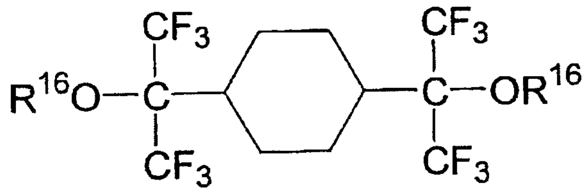

(D1-1)

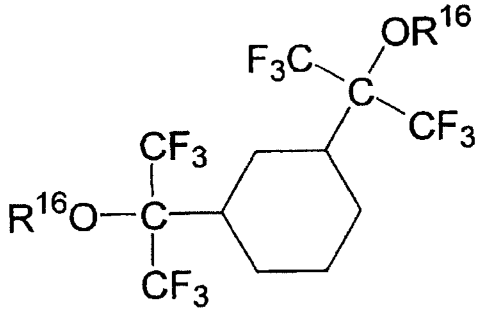

(D1-2)

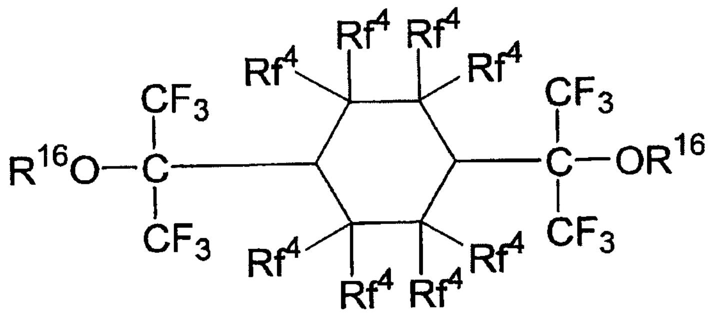

(D1-3)

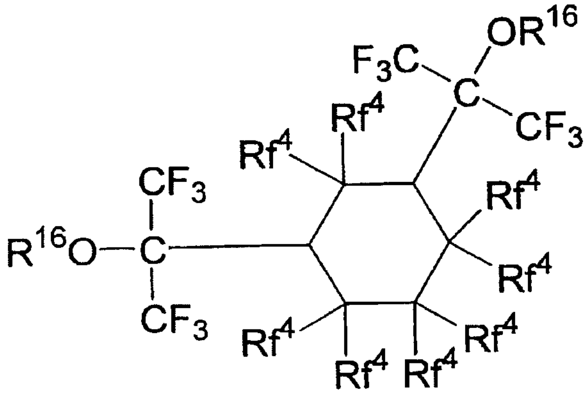

(D1-4)

wherein $R^{16}$ individually represents a hydrogen atom, t-butoxycarbonyl group, methoxymethyl group, ethoxymethyl group, 1-methoxyethyl group, or 1-ethoxyethyl group and $Rf^4$ individually represents a hydrogen atom, fluorine atom, or trifluoromethyl group, provided that eight $Rf^4$ groups in the formulas (D1-3) and (D1-4) cannot be a hydrogen atom at the same time.

As preferable examples of the dissolution controller (D2), compounds shown by the following formulas (D2-1) to (D2-5) can be given:

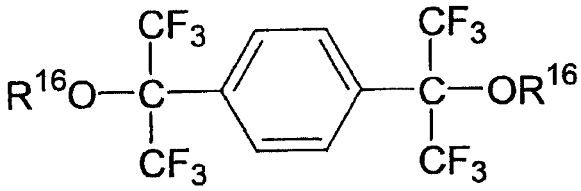

(D2-1)

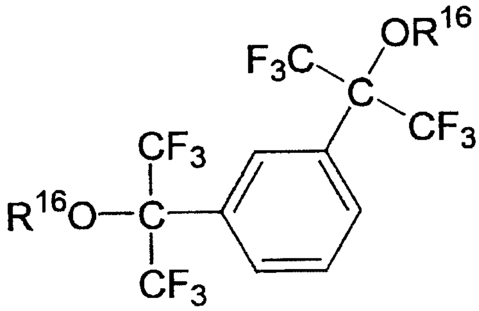

(D2-2)

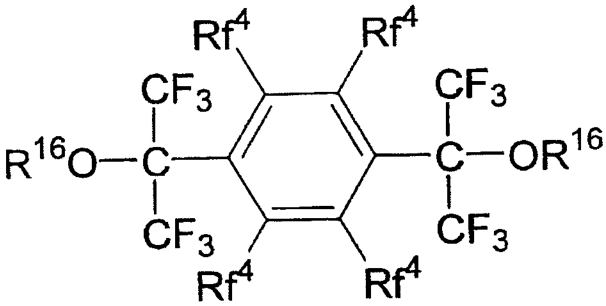

(D2-3)

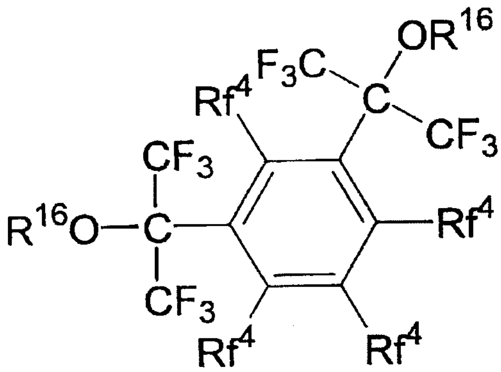

(D2-4)

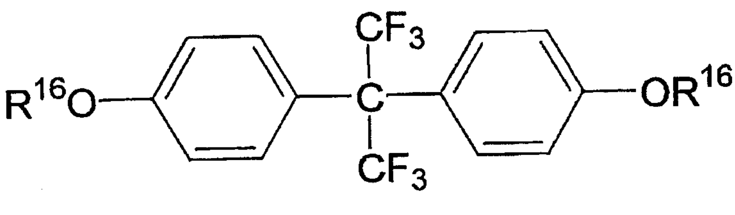

(D2-5)

wherein $R^{16}$ and $Rf^4$ are respectively the same as those defined in the above formulas (D1-1) to (D1-4), provided that four $Rf^4$ groups in the formulas (D2-3) and (D2-4) cannot be a hydrogen atom at the same time.

As the dissolution controller (D1), the compounds of the following formula (D1-1-1), formula (D1-1-2), formula (D1-2-1), and formula (D1-2-2), for example, are more preferable. As the dissolution controller (D2), the compounds of the following formula (D2-1-1), formula (D2-1-2), formula (D2-2-1), formula (D2-2-2), and formula (D2-5-1), for example, are more preferable.

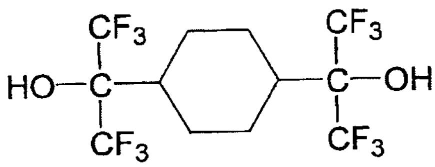
(D1-1-1)

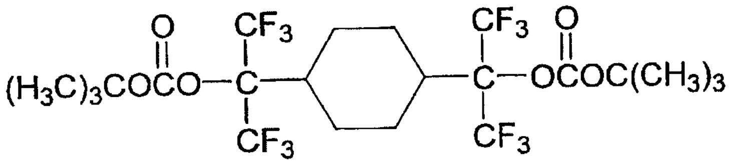
(D1-1-2)

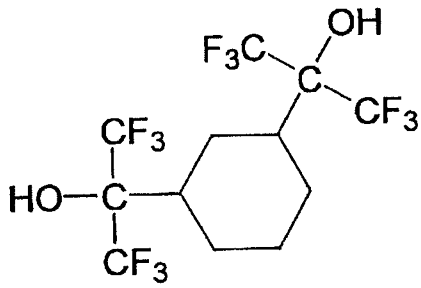
(D1-2-1)

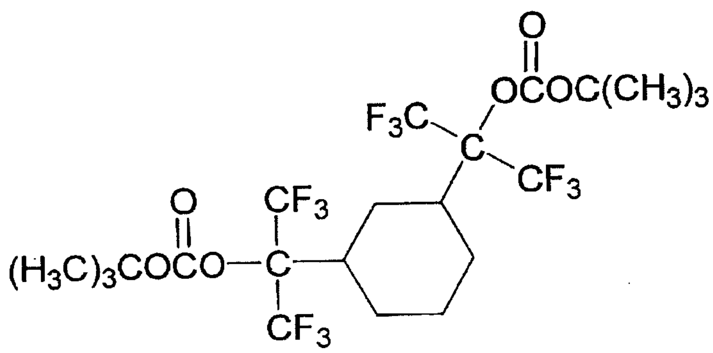
(D1-2-2)

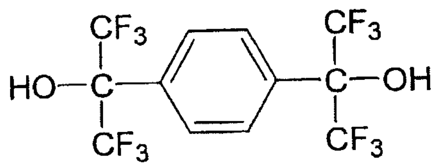
(D2-1-1)

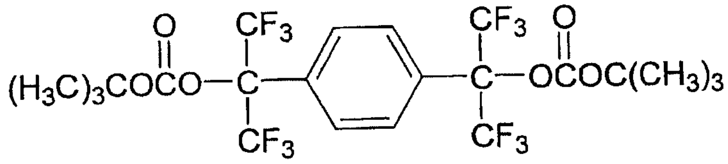

(D2-1-2)

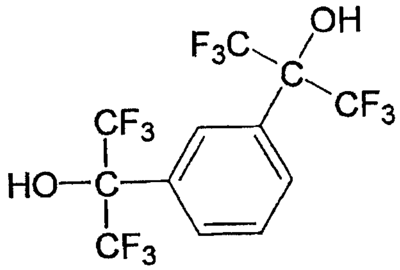

(D2-2-1)

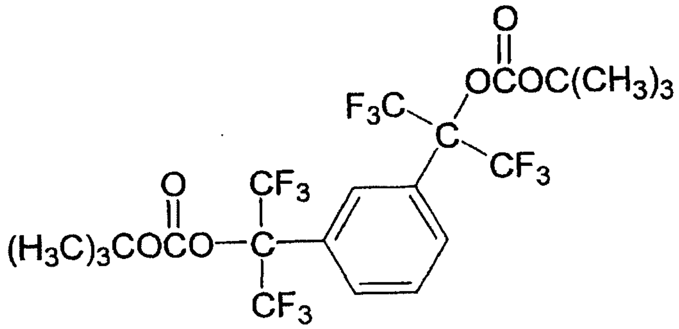

(D2-2-2)

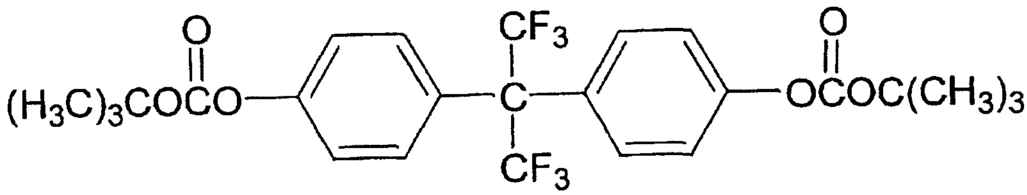

(D2-5-1)

As the dissolution controller (D4), a polyspiroketal having a recurring unit of the following formula (D4-1) is more preferable.

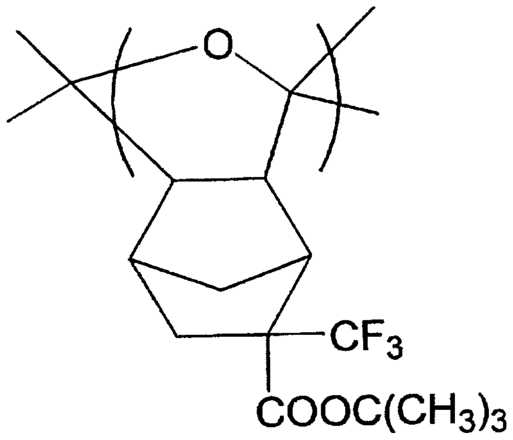

(D4-1)

The polyketone used as a dissolution controller (D3) and the polyspiroketal used as a dissolution controller (D4) have an Mw usually from 300 to 100,000, and preferably from 800 to 3,000. The amount of the dissolution controllers to be added is usually 50 parts by weight or less, and preferably 30 parts by weight or less for 100 parts by weight of the total resin component. If the amount of the dissolution controller exceeds 50 parts by weight, heat resistance as a resist tends to decrease.

The surfactant improves applicability, striation, developability, and the like of the radiation-sensitive resin composition.

As examples of the surfactant, nonionic surfactants such as polyoxyethylene lauryl ether, polyoxyethylene stearyl ether, polyoxyethylene oleyl ether, polyoxyethylene n-octyl phenyl ether, polyoxyethylene n-nonyl phenyl ether, polyethylene glycol dilaurate, and polyethylene glycol distearate; and commercially available products such as KP341 (manufactured by Shin-Etsu Chemical Co., Ltd.), POLYFLOW No. 75, No. 95 (manufactured by Kyoeisha Chemical Co., Ltd.), FTOP EF301, EF303, EF352 (manufactured by Tohkem Products Corp.), MEGAFAC F171, F173 (manufactured by Dainippon Ink and Chemicals, Inc.), Fluorad FC430, FC431 (manufactured by Sumitomo 3M Ltd.), Asahi Guard AG710, and Surflon S-382, SC-101, SC-102, SC-103, SC-104, SC-105, SC-106 (manufactured by Asahi Glass Co., Ltd.) can be given.

These surfactants may be used either individually or in combination of two or more.

The amount of the surfactants to be added is usually 2 parts by weight or less for 100 parts by weight of the total resin component.

As other additives, halation inhibitors, adhesion promoters, storage stabilizers, anti-foaming agents, and the like can be given.

The content of nitrogen-containing compounds other than the components (A) to (C) used in the radiation-sensitive resin composition of the present invention is not more than 100 ppm, preferably not more than 80 ppm, and particularly preferably not more than 50 ppm. Not only can superior depth of focus (DOF) be ensured, but also sensitivity change after storage can be excellently controlled by using the radiation-sensitive resin composition of the present invention.

Formation of resist pattern

In the radiation-sensitive resin composition of the present invention, an acid is generated from the acid generator (B) upon exposure to radiation. The acid-dissociable group in the siloxane resin (A) dissociates by the action of the acid and generates a carboxyl group or a hydroxyl group. As a result, solubility of the exposed part of the resist in an alkaline developer increases, whereby the exposed part is dissolved in an alkaline developer and removed to produce a positive-tone resist pattern.

A resist pattern is formed from the radiation-sensitive resin composition of the present invention by applying the composition solution to, for example, a silicon wafer, a wafer coated with aluminum, or a substrate with a previously formed under-layer film using an appropriate application method such as rotational coating, cast coating, and roll coating to form a resist film. Then, after optional pre-baking (hereinafter called "PB"), the resist film is exposed to radiation to form a prescribed resist pattern. Deep ultraviolet rays such as an $F_2$ excimer laser (wavelength: 157 nm) and ArF excimer laser (wavelength: 193 nm), electron beams, X-rays, and the like are preferable as the radiation used here.

In the present invention, it is preferable to perform post-exposure bake (hereinafter called "PEB") after exposure. The PEB ensures a smooth dissociation reaction of the acid-dissociable group from the siloxane resin (A). The heating

temperature for PEB is usually 30-200°C, and preferably 50-170°C, although the heating conditions vary depending on the composition of the resist.

In order to bring out the potential capability of the radiation-sensitive resin composition of the present invention to the maximum extent, it is possible to previously form an organic or inorganic under-layer film on the substrate used (e.g. Patent Document 9) or in order to prevent the effects of basic impurities contained in the environmental atmosphere, it is possible to prepare a protective film on the resist film (e.g. Patent Document 10). Combined used of these techniques is also possible.

[Patent Document 9] JP-B-6-12452

[Patent Document 10] JP-A-5-188598

The exposed resist film is then developed to form a prescribed resist pattern.

As examples of the developer used for development, alkaline aqueous solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, and 1,5-diazabicyclo-[4.3.0]-5-nonene are preferable.

The concentration of the alkaline aqueous solution is usually 10 wt% or less. If the concentration of the alkaline aqueous solution exceeds 10 wt%, an unexposed part may be dissolved in the developer.

Organic solvents or the like may be added to the developer containing the alkaline aqueous solution.

As examples of the organic solvents, ketones such as acetone, 2-butanone, 4-methyl-2-pentanone, cyclopentanone, cyclohexanone, 3-methylcyclopentanone, and 2,6-dimethylcyclohexanone; alcohols such as methyl alcohol, ethyl alcohol, n-propyl alcohol, i-propyl alcohol, n-butyl alcohol, t-butyl alcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, and dimethylformamide can be given.

These organic solvents may be used either individually or in combination of two or more.

The amount of the organic solvent to be used is preferably 100 vol% or less of the alkaline aqueous solution. The amount of the organic solvent exceeding 100 vol% may decrease developability, giving rise to a larger undeveloped portion in the exposed area.

In addition, surfactants or the like may be added to the developer containing the alkaline aqueous solution in an appropriate amount.

After development using the alkaline aqueous solution developer, the resist film is generally washed with water and dried.

BEST MODE FOR CARRYING OUT THE INVENTION

The present invention is described below in more detail by examples. However, these examples should not be construed as limiting the present invention.

In the examples, part(s) refer to part(s) by weight. Mw:

Mw of the siloxane resin (A) and polymers used for an under layer film-forming composition was measured by gel permeation chromatography (GPC) using GPC columns (manufactured by Tosoh Corp., G2000HXL × 2, G3000HXL × 1, G4000HXL × 1) under the following conditions. Flow rate: 1.0 ml/minute, eluate: tetrahydrofuran, column temperature: 40°C, standard reference material: monodispersed polystyrene

Synthesis Example 1 (Preparation of siloxane resin (A-1))

A three-necked flask equipped with a stirrer, a reflux condenser, and a thermometer was charged with 36.3 g of a silane compound shown by the following formula (i-1), 41.3 g of a silane compound shown by the following formula (ii-1) (hereinafter referred to as "silane compound (ii-1)"), 22.4 g of a silane compound shown by the following formula (iii-1) (hereinafter referred to as "silane compound (iii-1)"), 100 g of 4-methyl-2-pentanone, and 23.0 g of a 1.75 wt% aqueous solution of oxalic acid. The mixture was reacted at 60°C for six hours while stirring. The flask was cooled with ice to terminate the reaction.

34.0 g of distilled water and 47.7 g of triethylamine were added to the reaction solution and stirred at 80°C in a nitrogen stream for six hours, followed by cooling with ice. An aqueous solution of 35.9 g of oxalic acid dissolved in 476.5 g of distilled water was added to the mixture, followed by further stirring. The reaction solution was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 543 g of methanol, the mixture was stirred to obtain a homogeneous solution, which was poured

into a separation funnel. 868 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 62.1 g of a purified resin. Mw of the resin was 1,740. This resin is referred to as a "siloxane resin (A-1)".

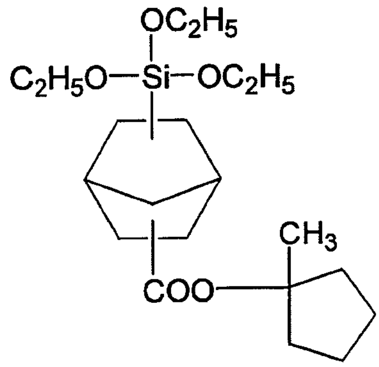

(i-1)

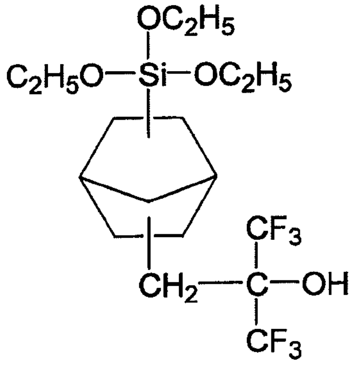

(ii-1)

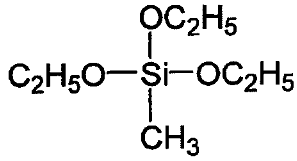

(iii-1)

The content of nitrogen-containing compounds in the siloxane resin (A-1) determined by the following method was less than 50 ppm.

Measurement of the content of nitrogen-containing compounds

The content of nitrogen-containing compounds was measured using an NPD (nitrogen phosphorous detector) of gas chromatography, HP5890 series manufactured by Hewlett Packard (column: HP-INNOWax (30m × 0.25 mm ID, 0.25 μm)), under the conditions of an He carrier flow rate of 1 ml/min, a sample feed rate of 0.5 μl, and a split ratio of 1/50, an injection temperature of 260°C, and a detection temperature of 260°C. A program consisting of sample holding at 50°C for six minutes, heating to 260°C at a GC oven heating rate of 30°C/min, and holding at 260°C for two minutes, followed by measurement was conducted. A calibration curve of the concentration was prepared using triethylamine used for the polymerization. The content of nitrogen-containing compounds was compared by the area percentage. The detectable lower limit was 50 ppm.

Synthesis Example 2 (Preparation of siloxane resin (A-2))

A three-necked flask equipped with a stirrer, a reflux condenser, and a thermometer was charged with 38.6 g of a silane compound shown by the following formula (i-2), 39.8 g of silane compound (ii-1), 21.6 g of silane compound (iii-1), 100 g of 4-methyl-2-pentanone, and 22.2 g of a 1.75 wt% aqueous solution of oxalic acid. The mixture was reacted at 60°C for six hours while stirring. The flask was cooled with ice to terminate the reaction.

32.8 g of distilled water and 46.0 g of triethylamine were added to the reaction solution and stirred at 80°C in a nitrogen stream for six hours, followed by cooling with ice. An aqueous solution of 34.6 g of oxalic acid dissolved in 459.3 g of distilled water was added to the mixture, followed by further stirring. The reaction solution was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 543 g of methanol, the mixture was stirred to obtain a homogeneous solution, which was poured into a separation funnel. 868 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 65.0 g of a purified resin. Mw of the resin was 1,740. This resin is referred to as a "siloxane resin (A-2)".

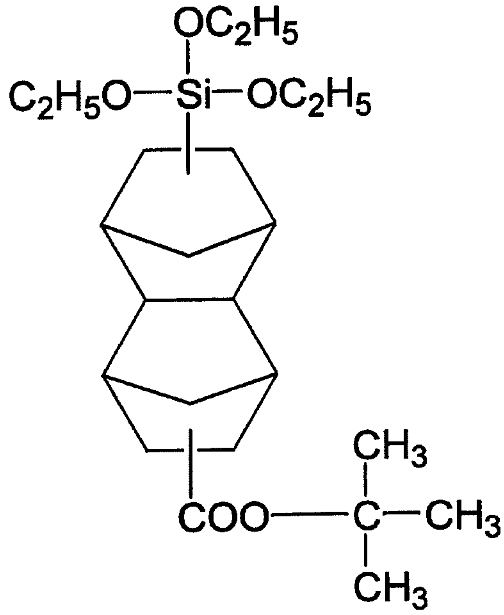

(i-2)

The content of nitrogen-containing compounds in the siloxane resin (A-2) determined by the same method as in Synthetic Example 1 was less than 50 ppm.

Preparation Example (Preparation of under layer film-forming composition)

A separable flask equipped with a thermometer was charged with 100 parts of acenaphthylene, 78 parts of toluene, 52 parts of dioxane, and 3 parts of azobisisobutyronitrile under nitrogen atmosphere. The mixture was stirred for 5 hours at 70°C. Next, 5.2 parts of p-toluenesulfonic acid monohydrate and 40 parts of paraformaldehyde were added. After heating to 120°C, the mixture was stirred for 6 hours. The reaction solution was poured into a large amount of isopropyl alcohol. The resulting precipitate was collected by filtration and dried at 40°C under reduced pressure to obtain a polymer having a Mw of 22,000.

10 parts of the obtained polymer, 0.5 part of bis(4-t-butylphenyl)iodonium 10-camphorsulfonate, and 0.5 part of 4,4'-[1-{4-(1-[4-hydroxyphenyl]-1-methylethyl)phenyl}ethylidene]bisphenol were dissolved in 89 parts of cyclohexanone. The solution was filtered using a membrane filter with a pore diameter of 0.1 μm to prepare an under layer film-forming composition.

Examples 1-2 and Comparative Examples 1-4

Resin compositions were prepared by homogeneously mixing siloxane resins (A) shown in Table 1, 900 parts of 2-heptanone, and the acid generators (B) shown Table 1. For Comparative Examples 1-4, triethylamine was added as a nitrogen-containing compound in amounts (ppm) indicated in Table 1.

The resin compositions were applied onto a silicon wafer substrate with an under layer film previously formed thereon by spin coating and pre-baked at a temperature for a period of time shown in Table 2 on a hot plate to form a resist film with a thickness of 150 nm.

The under layer film had a thickness of 300 nm, prepared by applying the above-mentioned under layer film-forming composition onto a silicon wafer by spin coating and baking the coating on a hot plate at 180°C for 60 seconds and further baking at 300°C for 120 seconds.

Each resist film was exposed by changing the amount of exposure using an ArF excimer laser (wavelength: 193 nm, NA: 0.78, σ: 0.85). PEB of each resist film was conducted on a hot plate at a temperature for a period of time shown in Table 2. The resist films were developed using a 2.38 wt% tetramethylammonium hydroxide aqueous solution at 23°C for 60 seconds, washed with water, and dried to form positive-tone resist patterns.

The evaluation was conducted according to the following procedure. The evaluation results are shown in Table 3.

Sensitivity

An optimum dose (Eop[1]) at which a line-and-space (1L1S) pattern with a line width of 100 nm was formed was taken as sensitivity.

Sensitivity change

The composition solutions were stored at 35°C for two months and positive-tone resist patterns were formed in the same manner as above. An optimum dose (Eop[2]) at which a line-and-space (1L1S) pattern with a line width of 100 nm was formed was taken as sensitivity to evaluate the sensitivity change according to the following formula.

$$\text{Sensitivity change} = \text{Eop}[1] \times 100/\text{Eop}[2]$$

Depth of focus (DOF)

A line-and-space pattern (1L1S) with a line width of 90 nm was formed by irradiating light at an optimum exposure dose (Eop[1]) while moving the focus to determine a focus range in which the line width of the line pattern was from 81 nm to 99 nm.

The acid generators (B) in Table 1 are as follows.

Acid generator (B)

B-1: bis(4-t-butylphenyl)iodonium nonafluoro-n-butanesulfonate
B-2: Triphenylsulfonium 10-camphorsulfonate

Table 1

| | Siloxane resin (A) (part) | Acid generator (B) (part) | Triethylamine (ppm) |
|---|---|---|---|
| Example 1 | A-1 (100) | B-1 (5.0) B-2 (1.5) | - |
| Example 2 | A-2 (100) | B-1 (5.0) B-2 (1.5) | - |
| Comparative Example 1 | A-1 (100) | B-1 (5.0) B-2 (1.5) | 150 |
| Comparative Example 2 | A-1 (100) | B-1 (5.0) B-2 (1.5) | 1,500 |
| Comparative Example 3 | A-2 (100) | B-1 (5.0) B-2 (1.5) | 150 |
| Comparative Example 4 | A-2 (100) | B-1 (5.0) B-2 (1.5) | 1,500 |

Table 2

| | PB | | PEB | |
|---|---|---|---|---|
| | Temperature (°C) | Period (sec) | Temperature (°C) | Period (sec) |
| Example 1 | 100 | 90 | 100 | 90 |
| Example 2 | 80 | 90 | 80 | 90 |
| Comparative Example 1 | 100 | 90 | 100 | 90 |
| Comparative Example 2 | 100 | 90 | 100 | 90 |
| Comparative Example 3 | 80 | 90 | 80 | 90 |
| Comparative Example 4 | 80 | 90 | 80 | 90 |

Table 3

| | Sensitivity ($J/m^2$) | Eop [2] ($J/m^2$) | Change in sensitivity (%) | DOF (μm) |
|---|---|---|---|---|
| Example 1 | 360 | 360 | 100.0 | 0.8 |
| Example 2 | 310 | 310 | 100.0 | 0.8 |
| Comparative Example 1 | 390 | 350 | 111.4 | 0.6 |
| Comparative Example 2 | 440 | <300 | >146.7 | 0.4 |
| Comparative Example 3 | 330 | 300 | 115.2 | 0.7 |
| Comparative Example 4 | 380 | <200 | >190 | 0.5 |

## INDUSTRIAL APPLICABILITY

The radiation-sensitive resin composition of the present invention has high transparency at a wavelength of 193 nm or less, exhibits particularly excellent depth of focus (DOF) and extremely controlled change in the sensitivity after storage, and excels in sensitivity, resolution, pattern forming-capability, and the like, when used as a chemically-amplified resist. Therefore, the radiation-sensitive resin composition of the present invention can be extremely suitable for manufacturing LSIs which will become more and more minute in the future.

## Claims

1. A radiation-sensitive resin composition comprising (A) a siloxane resin having a structural unit (I) shown by the following formula (I) and/or a structural unit (II) shown by the following formula (II), (B) a photoacid generator, and (C) a solvent, the content of nitrogen-containing compounds other than the components (A) to (C) in the composition being not more than 100 ppm,

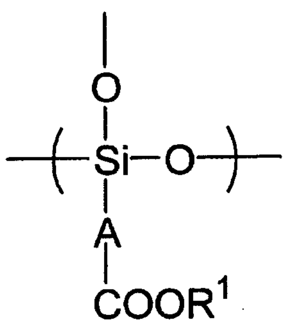

(I)

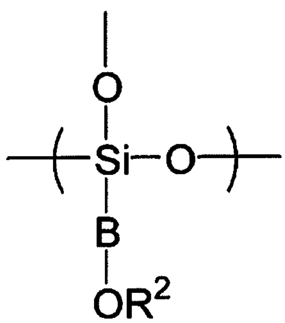

(II)

wherein A represents a substituted or unsubstituted divalent linear, branched, or cyclic hydrocarbon group having 1 to 20 carbon atoms, $R^1$ represents a monovalent acid-dissociable group, B represents a substituted or unsubstituted divalent linear, branched, or cyclic hydrocarbon group having 1 to 20 carbon atoms, and $R^2$ represents a hydrogen atom or a monovalent acid-dissociable group.

2. The radiation-sensitive resin composition according to claim 1, wherein $R^1$ in the structural unit (I) is a t-butyl group, 1-methylcyclopentyl group, 1-ethylcyclopentyl group, 1-methylcyclohexyl group, 1-ethylcyclohexyl group, 2-methyladamantan-2-yl group, 2-ethyladamantan-2-yl group, or t-butoxycarbonylmethyl group, and $R^2$ in the structural unit (II) is a hydrogen atom, methoxymethyl group, ethoxymethyl group, n-propoxymethyl group, n-butoxymethyl group, or t-butoxycarbonyl group.

3. The radiation-sensitive resin composition according to claim 1, wherein the structural unit (I) comprises one or more units shown by the following formulas (I-1) to (I-5) and the structural unit (II) comprises one or more units shown by

the following formulas (II-1) to (II-10),

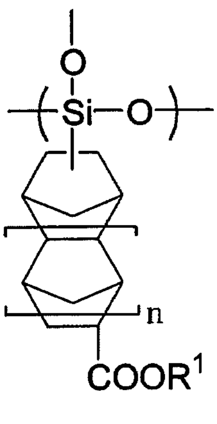

(I-1)

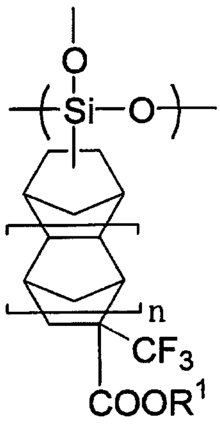

(I-2)

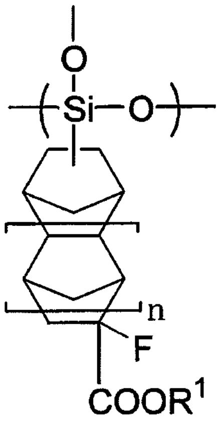

(I-3)

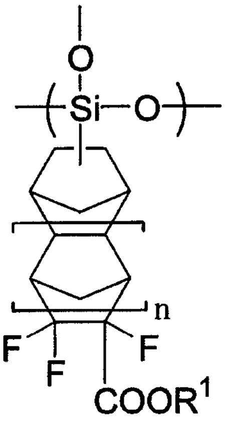

(I-4)

wherein n is 0 or 1 and $R^1$ individually represents a monovalent acid-dissociable group,

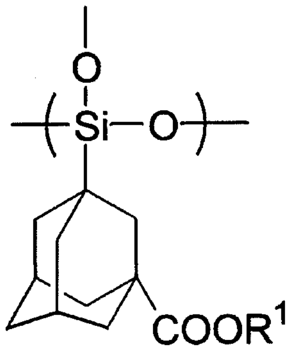

(I-5)

wherein $R^1$ represents a monovalent acid-dissociable group,

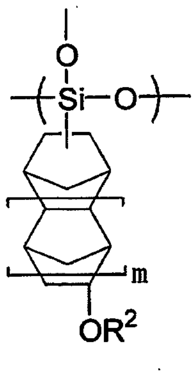

(II-1)

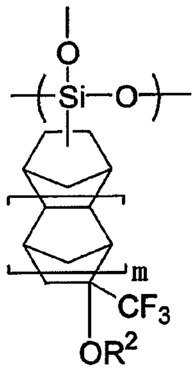

(II-2)

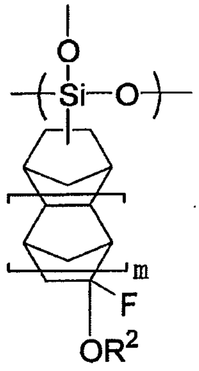

(II-3)

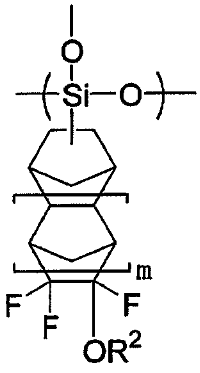

(II-4)

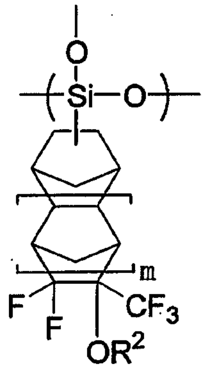

(II-5)

wherein m is 0 or 1 and $R^2$ individually represents a hydrogen atom or a monovalent acid-dissociable group,

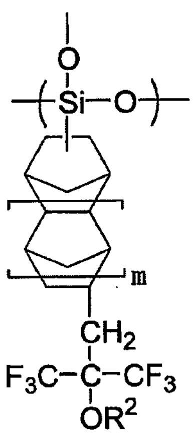

(II-6)

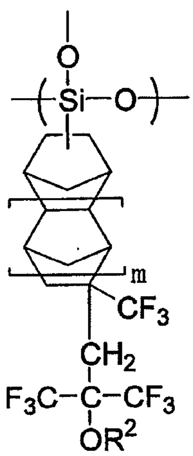

(II-7)

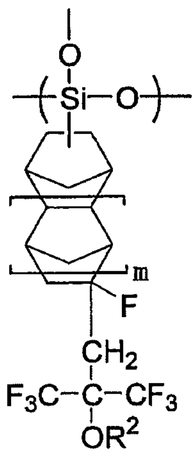

(II-8)

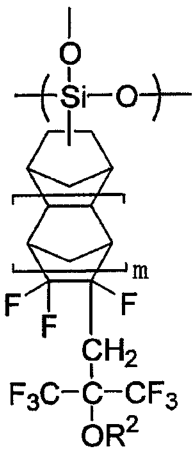

(II-9)

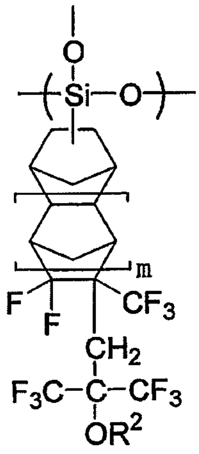

(II-10)

wherein m is 0 or 1 and $R^2$ individually represents a hydrogen atoms or a monovalent acid-dissociable group.

4. The radiation-sensitive resin composition according to claim 3, wherein $R^1$ in the units shown by the formulas (I-1) to (I-5) is a t-butyl group, 1-methylcyclopentyl group, 1-ethylcyclopentyl group, 1-methylcyclohexyl group, 1-ethylcyclohexyl group, 2-methyladamantan-2-yl group, 2-ethyladamantan-2-yl group, or t-butoxycarbonylmethyl group, and $R^2$ in the units shown by the formulas (II-1) to (II-10) is a hydrogen atom, methoxymethyl group, ethoxymethyl group, n-propoxymethyl group, n-butoxymethyl group, or t-butoxycarbonyl group.

5. The radiation-sensitive resin composition according to any one of claims 1 to 4, wherein the photoacid generator (B) is a compound generating an acid shown by the following formula (3),

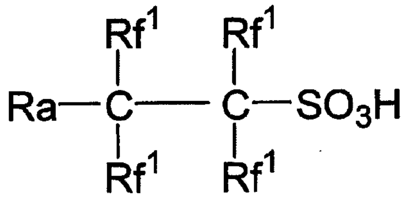

(3)

wherein $Rf^1$ individually represents a fluorine atom or trifluoromethyl group and Ra represents a hydrogen atom, fluorine atom, linear or branched alkyl group having 1 to 20 carbon atoms, linear or branched fluoroalkyl group having 1 to 20 carbon atoms, substituted or unsubstituted monovalent cyclic hydrocarbon group having 3 to 20 carbon atoms, or substituted or unsubstituted monovalent cyclic fluorohydrocarbon group having 3 to 20 carbon atoms.

**6.** The radiation-sensitive resin composition according to claim 5, wherein Ra in the formula (3) is a methyl group, ethyl group, n-propyl group, i-propyl group, n-butyl group, i-butyl group, sec-butyl group, t-butyl group, n-pentyl group, n-hexyl group, n-heptyl group, or n-octyl group.

**7.** The radiation-sensitive resin composition according to claim 5, wherein the photoacid generator (B) further comprises a compound generating an acid of the following formula (4), an acid of the following formula (5), or an acid of the following formula (6),

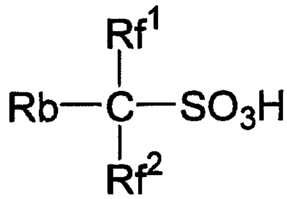

(4)

**Rs- SO3H (5)**

**Rc- COOH (6)**

wherein, in the formula (4), $Rf^1$ represents a fluorine atom or trifluoromethyl group, $Rf^2$ represents a hydrogen atom, fluorine atom, methyl group, or trifluoromethyl group, Rb represents a hydrogen atom, a linear or branched alkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms, in the formula (5), Rs represents a linear or branched alkyl group having 1 to 20 carbon atoms or a substituted or unsubstituted monovalent cyclic hydrocarbon group having 3 to 20 carbon atoms, and in the formula (6), Rc represents a linear or branched alkyl group having 1 to 20 carbon atoms, a linear or branched fluoroalkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms.

**8.** The radiation-sensitive resin composition according to claim 7, wherein Ra of the acid shown by the formula (3), Rb of the acid shown by the formula (4), Rs of the acid shown by the formula (5), and Rc of the acid shown by the formula (6) are individually a methyl group, ethyl group, n-propyl group, i-propyl group, n-butyl group, i-butyl group, sec-butyl group, t-butyl group, n-pentyl group, n-hexyl group, n-heptyl group, or n-octyl group.

**9.** The radiation-sensitive resin composition according to any one of claims 1 to 4, wherein the total content of the structural unit (I) and the structural unit (II) is 20 to 60 mol%.

**10.** The radiation-sensitive resin composition according to any one of claims 1 to 4, wherein the content of the structural unit (I) is 15 to 50 mol% and the content of the structural unit (II) is 3 to 40 mol%.

**11.** A radiation-sensitive resin composition comprising (A) a siloxane resin having a structural unit (I) shown by the following formula (I) and/or a structural unit (II) shown by the following formula (II) and a structural unit (III) shown by the following formula (III), (B) a photoacid generator, and (C) a solvent, the content of nitrogen-containing compounds other than the components (A) to (C) in the composition being not more than 100 ppm,

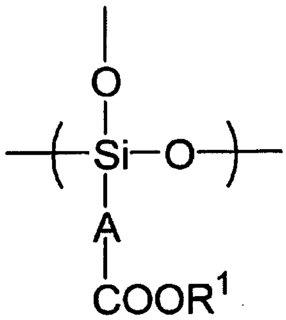

(I)

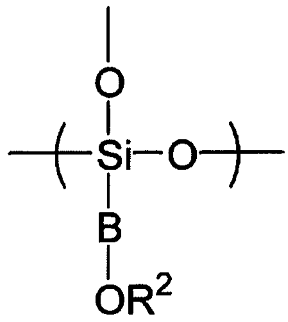

(II)

wherein A represents a substituted or unsubstituted divalent linear, branched, or cyclic hydrocarbon group having 1 to 20 carbon atoms, $R^1$ represents a monovalent acid-dissociable group, and B represents a substituted or unsubstituted divalent linear, branched, or cyclic hydrocarbon group having 1 to 20 carbon atoms, and $R^2$ represents a hydrogen atom or a monovalent acid-dissociable group, and

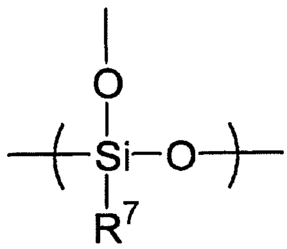

(III)

wherein $R^7$ represents a substituted or unsubstituted monovalent hydrocarbon group having 1 to 20 carbon atoms or a substituted or unsubstituted monovalent heterocyclic group having 3 to 20 atoms.

**12.** The radiation-sensitive resin composition according to claim 11, wherein $R^1$ in the structural unit (I) is a t-butyl group, 1-methylcyclopentyl group, 1-ethylcyclopentyl group, 1-methylcyclohexyl group, 1-ethylcyclohexyl group, 2-methyladamantan-2-yl group, 2-ethyladamantan-2-yl group, or t-butoxycarbonylmethyl group, and $R^2$ in the structural unit (II) is a hydrogen atom, methoxymethyl group, ethoxymethyl group, n-propoxymethyl group, n-butoxymethyl group, or t-butoxycarbonyl group.

**13.** The radiation-sensitive resin composition according to claim 11, wherein the structural unit (I) comprises one or more units shown by the following formulas (I-1) to (I-5) and the structural unit (II) comprises one or more units shown by the following formulas (II-1) to (II-10),

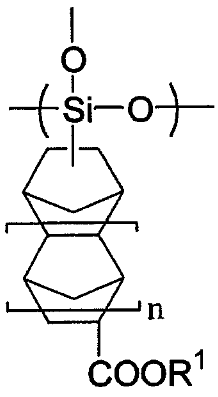
(I-1)

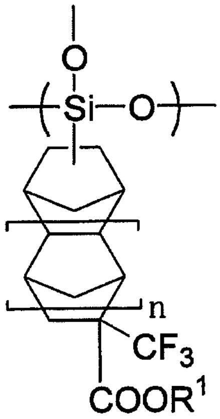
(I-2)

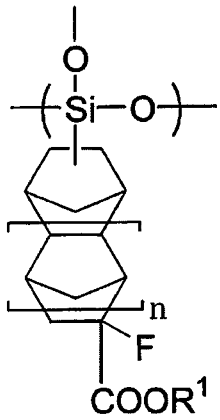
(I-3)

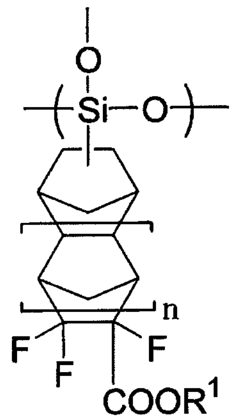
(I-4)

wherein n is 0 or 1 and $R^1$ individually represents a monovalent acid-dissociable group,

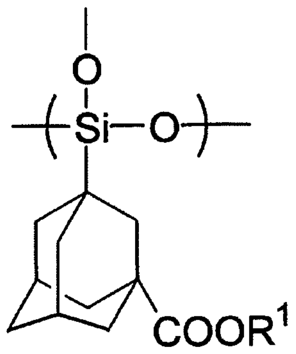
(I-5)

wherein $R^1$ represents a monovalent acid-dissociable group,

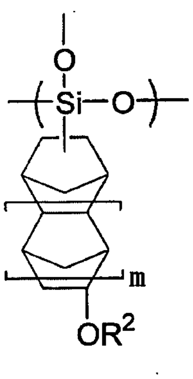
(II-1)

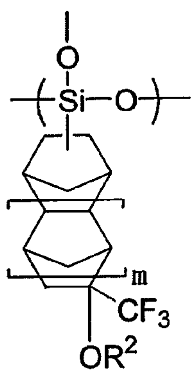
(II-2)

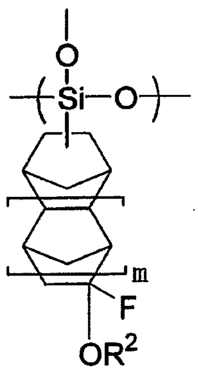
(II-3)

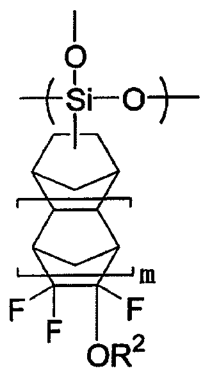
(II-4)

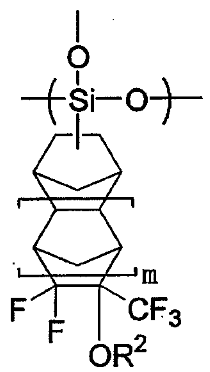
(II-5)

wherein m is 0 or 1 and $R^2$ individually represents a hydrogen atoms or a monovalent acid-dissociable group,

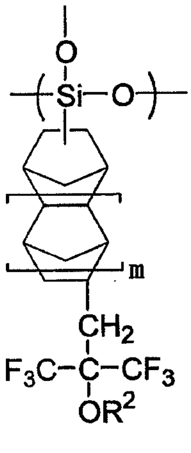
(II-6)

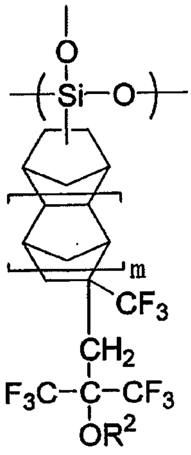
(II-7)

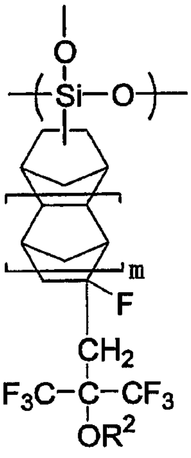
(II-8)

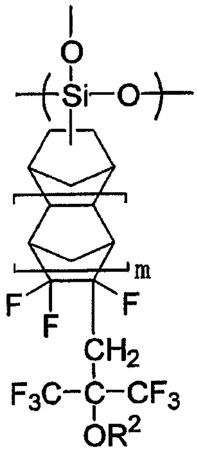
(II-9)

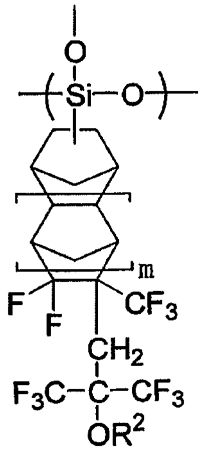
(II-10)

wherein m is 0 or 1 and $R^2$ individually represents a hydrogen atoms or a monovalent acid-dissociable group.

**14.** The radiation-sensitive resin composition according to claim 13, wherein $R^1$ in the units shown by the formulas (I-1) to (I-5) is a t-butyl group, 1-methylcyclopentyl group, 1-ethylcyclopentyl group, 1-methylcyclohexyl group, 1-ethylcyclohexyl group, 2-methyladamantan-2-yl group, 2-ethyladamantan-2-yl group, or t-butoxycarbonylmethyl group, and $R^2$ in the units shown by the formulas (II-1) to (II-10) is a hydrogen atom, methoxymethyl group, ethoxymethyl group, n-propoxymethyl group, n-butoxymethyl group, or t-butoxycarbonyl group.

**15.** The radiation-sensitive resin composition according to any one of claims 11 to 14, wherein the photoacid generator (B) is a compound generating an acid shown by the following formula (3),

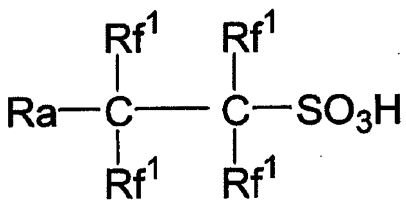
(3)

wherein $Rf^1$ individually represents a fluorine atom or trifluoromethyl group and Ra represents a hydrogen atom, fluorine atom, linear or branched alkyl group having 1 to 20 carbon atoms, linear or branched fluoroalkyl group having 1 to 20 carbon atoms, substituted or unsubstituted monovalent cyclic hydrocarbon group having 3 to 20 carbon atoms, or substituted or unsubstituted monovalent cyclic fluorohydrocarbon group having 3 to 20 carbon atoms.

**16.** The radiation-sensitive resin composition according to claim 15, wherein Ra of the acid shown by the formula (3) is a methyl group, ethyl group, n-propyl group, i-propyl group, n-butyl group, i-butyl group, sec-butyl group, t-butyl group, n-pentyl group, n-hexyl group, n-heptyl group, or n-octyl group.

**17.** The radiation-sensitive resin composition according to claim 15, wherein the photoacid generator (B) further comprises a compound generating an acid of the following formula (4), an acid of the following formula (5), or an acid of the following formula (6),

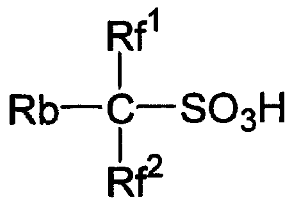

(4)

**Rs- SO3H (5)**

**Rc- COOH (6)**

wherein, in the formula (4), $Rf^1$ represents a fluorine atom or trifluoromethyl group, $Rf^2$ represents a hydrogen atom, fluorine atom, methyl group, or trifluoromethyl group, Rb represents a hydrogen atom, a linear or branched alkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms, in the formula (5), Rs represents a linear or branched alkyl group having 1 to 20 carbon atoms or a substituted or unsubstituted monovalent cyclic hydrocarbon group having 3 to 20 carbon atoms, and in the formula (6), Rc represents a linear or branched alkyl group having 1 to 20 carbon atoms, a linear or branched fluoroalkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms.

**18.** The radiation-sensitive resin composition according to claim 17, wherein Ra of the acid shown by the formula (3), Rb of the acid shown by the formula (4), Rs of the acid shown by the formula (5), and Rc of the acid shown by the formula (6) are individually a methyl group, ethyl group, n-propyl group, i-propyl group, n-butyl group, i-butyl group, sec-butyl group, t-butyl group, n-pentyl group, n-hexyl group, n-heptyl group, or n-octyl group.

**19.** The radiation-sensitive resin composition according to any one of claims 11 to 14, wherein the total content of the structural unit (I) and the structural unit (II) is 20 to 60 mol%.

**20.** The radiation-sensitive resin composition according to any one of claims 11 to 14, wherein the content of the structural unit (I) is 15 to 50 mol% and the content of the structural unit (II) is 3 to 40 mol%.

**INTERNATIONAL SEARCH REPORT**

International application No.
PCT/JP2005/007123

A. CLASSIFICATION OF SUBJECT MATTER
Int.Cl$^7$ G03F7/075, 7/004, 7/039, H01L21/027

According to International Patent Classification (IPC) or to both national classification and IPC

B. FIELDS SEARCHED

Minimum documentation searched (classification system followed by classification symbols)
Int.Cl$^7$ G03F7/004-7/18, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2003-173027 A (JSR Corp.), 20 June, 2003 (20.06.03), Full text & US 2003/113658 A1 & EP 1270553 A & CN 1432873 A | 1-20 |
| Y | JP 2003-20335 A (JSR Corp.), 24 January, 2003 (24.01.03), Full text & US 2004/143082 A1 & EP 1398339 A1 & CN 1505651 A & TW 594389 B & WO 2002/90423 A1 | 1-20 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 May, 2005 (09.05.05) | 24 May, 2005 (24.05.05) |

| Name and mailing address of the ISA/ | Authorized officer |
|---|---|
| Japanese Patent Office | |
| Facsimile No. | Telephone No. |

Form PCT/ISA/210 (second sheet) (January 2004)

**INTERNATIONAL SEARCH REPORT**

International application No.
PCT/JP2005/007123

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 2001-288268 A (JSR Corp.),<br>16 October, 2001 (16.10.01),<br>Full text<br>& US 2001/41769 A1 & EP 1142928 A1<br>& TW 588071 B | 1-4,11-14<br>5-10,15-20 |
| Y | JP 2001-98009 A (Shipley Co., L.L.C.),<br>10 April, 2001 (10.04.01),<br>Full text<br>(Family: none) | 1-20 |
| Y | JP 2001-42530 A (Shipley Co., L.L.C.),<br>16 February, 2001 (16.02.01),<br>Full text<br>(Family: none) | 1-20 |

Form PCT/ISA/210 (continuation of second sheet) (January 2004)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5323611 A
- JP 8160623 A
- JP 11060733 A
- JP 2000221685 A
- JP 2000221686 A
- JP 2002268225 A
- JP 2002268226 A
- JP 2002268227 A
- JP 6012452 B
- JP 5188598 A


### Non-patent literature cited in the description


- *J. Photopolym. Sci. Technol.,* 1999, vol. 12 (4), 561-570
- *SPIE,* 1999, vol. 3678, 13-23